# EUROPÄISCHE PATENTSCHRIFT

(11) **EP 2 742 785 B1**
(45) Veröffentlichungstag und Bekanntmachung des Hinweises auf die Patenterteilung: **12.06.2019**
(21) Anmeldenummer: 12742872.0
(22) Anmeldetag: 26.07.2012
(51) Int. Cl.: H05K 7/14, H01R 9/26

(54) **MODULARE STEUERUNGSVORRICHTUNG**
MODULAR CONTROL APPARATUS
DISPOSITIF DE COMMANDE MODULAIRE

(30) Priorität: 09.08.2011 DE 102011110182
(43) Veröffentlichungstag der Anmeldung: 18.06.2014
(73) Patentinhaber: Pilz GmbH & Co. KG, 73760 Ostfildern (DE)
(72) Erfinder: GODAU, Thorsten, 73760 Ostfildern (DE); CECH, Markus, 73760 Ostfildern (DE); GRUBER, Winfried, 73760 Ostfildern (DE); VEIT, Andreas, 73760 Ostfildern (DE)
(74) Vertreter: Witte, Weller & Partner Patentanwälte mbB
(86) Internationale Anmeldenummer: PCT/EP2012/064684
(87) Internationale Veröffentlichungsnummer: WO 2013/020819

(56) Entgegenhaltungen:
- EP-A1- 1 524 890
- EP-A2- 0 681 421
- EP-A2- 0 909 122
- EP-A2- 1 137 334
- DE-A1- 3 720 099
- DE-A1- 19 807 710
- DE-U1-202005 015 792
- DE-U1-202010 004 408

## Beschreibung

Die vorliegende Erfindung betrifft eine Steuerungsvorrichtung zum automatisierten Steuern einer technischen Anlage, insbesondere eine modulare Steuervorrichtung. Die Steuerungsvorrichtung hat zumindest ein Modul, das zumindest ein erstes Modulteil, ein zweites Modulteil, und ein drittes Modulteil umfasst. Das erste Modulteil und das zweite Modulteil können mechanisch und elektrisch in eine erste zusammengesetzte Anordnung zusammengesetzt werden. Das erste Modulteil und das dritte Modulteil können mechanisch und elektrisch in eine zweite zusammengesetzte Anordnung zusammengesetzt werden. Das erste Modulteil umfasst ein Sicherungselement, das in eine erste und eine zweite Position beweglich ist. Das Sicherungselement ist in seiner ersten Position mit dem zweiten Modulteil in der ersten zusammengesetzten Anordnung im sichernden Eingriff, so dass das erste Modulteil und das zweite Modulteil aneinander gesichert sind. Das Sicherungselement ist in seiner zweiten Position in der ersten zusammengesetzten Anordnung dergestalt, dass das erste Modulteil und das zweite Modulteil voneinander lösbar sind. Das Sicherungselement umfasst einen Sicherungsbetätigungsabschnitt mittels dessen das Sicherungselement in der ersten zusammengesetzten Anordnung zwischen der ersten und zweiten Position beweglich ist bei Ausüben einer Kraft auf den Sicherungsbetätigungsabschnitt.

Eine Steuerungsvorrichtung und ein Modul bzw. Modulteil dieser Art sind aus US 2003/0143896 A1 bekannt.

Eine Steuerungsvorrichtung im Sinne der vorliegenden Erfindung kann beispielsweise eine modulare Steuerungsvorrichtung für eine konfigurierbare oder programmierbare Steuerung sein. Es kann eine konfigurierbare Steuerung sein, wie beispielsweise jene, die die Anmelderin der vorliegenden Erfindung unter der Marke PNOZ® vertreibt, oder eine programmierbare Steuerung, wie beispielsweise jene die die Anmelderin der vorliegenden Erfindung unter der Marke PSS® vertreibt, oder eine dieser ähnliche. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Insbesondere stellt PSSuniversal® eine modulare programmierbare Steuerungsvorrichtung für Standard- und Sicherheitsaufgaben bereit, wie aus der Beschreibung "Pilz, PSSuniversal, Programmable Control Systems PSS®, System Description, No. 21256-EN-04" bekannt. Ein Modul umfasst hier ein erstes Modulteil in Form eines Elektronikmodulteils und ein zweites Modulteil in Form eines Basismodulteils, oder im Folgenden auch Busmodulteil genannt. Das Elektronikmodulteil wird durch eine lineare Bewegung auf das Busmodulteil gesteckt.

Das Elektronikmodulteil hat in diesem System zwei verschiedene Bauformen. In einer ersten Bauform kann Elektronikmodulteil ein Ein-/Ausgabemodulteil sein (z.B. für Fail Safe(FS)- oder Standard(ST)-Anwendungen). In einer zweiten Bauform kann das Elektronikmodulteil ein Spannungsversorgungsmodulteil, oder auch Einspeisemodul genannt, sein zur Einspeisung eines Module Supply, d.h. einer internen Versorgungsspannung, oder zur Einspeisung eines Periphery Supply, d.h. einer externen Versorgungsspannung. Es können so mehrere Potenzialgruppen gebildet werden. Für die erste Bauform (Ein-/Ausgabemodulteil) wird ein entsprechendes Busmodulteil verwendet, das in beiden Richtungen (nach rechts und nach links) der Längsrichtung Busanschlüsse aufweist, um die Versorgungsspannung von dem links danebenliegenden Modul auf das rechts danebenliegende Modul durchzuschalten. Diese Bauart wird daher auch Bauart mit durchgeschaltetem Bus genannt. Für die zweite Bauform (Spannungsversorgungsmodulteil) wird ein entsprechendes Busmodulteil benötigt, das in eine erste Richtung (z.B. nach links) keine Verbindung zum Versorgungsspannungsbus aufweist und in die andere Richtung (z.B. nach rechts) eine Verbindung zum Versorgungsspannungsbus aufweist, um die Versorgungsspannung nur an die rechts danebenliegenden Module weiterzuleiten. Das heißt, bei Bildung einer neuen Potenzialgruppe muss die Verbindung auf dem Versorgungsspannungsbus durch ein entsprechendes Busmodulteil aufgetrennt werden. Diese Bauform wird daher auch Bauform mit aufgetrenntem Bus genannt. Es müssen also zwei Bauformen des zweiten Modulteils (Busmodulteil) bereitgestellt werden, zum einen mit durchgeschaltetem Bus und zum anderen mit aufgetrenntem Bus.

Die externen Anschlüsse sind in diesem System in dem Busmodulteil integriert, so dass das Elektronikmodulteil, das auf dem Busmodulteil angeordnet ist, ausgetauscht werden kann, ohne dass die an den externen Anschlüssen des Busmodulteils anliegenden Verdrahtungen ausgetauscht werden müssen, d.h. ohne neu zu verdrahten.

Es kann andererseits jedoch gewünscht sein, dass die Art oder Anzahl der Anschlüsse anpassbar bzw. veränderbar ist. Eine Steuerungsvorrichtung im Sinne der vorliegenden Erfindung kann daher eine Steuerungsvorrichtung mit einem Modul mit drei Modulteilen sein. Eine solche ist beispielsweise durch das X20-System von B&R bekannt, wie aus der Beschreibung "X20-System, User's Manual, Version: 2.10 (May 2009), Model number: MAX20-ENG" ersichtlich. Ein Modul umfasst hier ein erstes Modulteil in Form eines Elektronikmodulteils, ein zweites Modulteil in Form eines Busmodulteils und ein drittes Modulteil in Form eines Feldklemmenmodulteils, oder auch Anschlussmodulteil genannt. Die externen Anschlüsse sind in diesem System in einem separaten Anschlussmodulteil untergebracht.

Die eingangs genannte US 2003/0143896 A1 beschreibt ebenfalls drei Modulteile. Auf ein Basismodulteil kann jeweils ein Elektronikmodulteil aufgesetzt werden und ein Anschlussklemmenblock (Anschlussmodulteil) kann auf der Vorderseite des Elektronikmodulteils aufgesetzt werden. Das Basismodulteil hat Aussparungen, die mit Rastungen, elastischen Teilen oder anderen Sicherungsteilen des Elektronikmodulteils zusammenwirken. Die Sicherungsteile können durch zwei Schieber bewegt werden, um das Elektronikmodulteil in einer in dem Basismodulteil eingebetteten Position zu sichern.

Ein Problem solcher Steuerungsvorrichtungen ist, dass das Elektronikmodulteil mit aufgesetztem Anschlussmodulteil von dem Busmodulteil abgezogen werden kann, wenn das Modul noch im Einsatz ist, beispielsweise wenn Spannungen oder Signale an den Anschlüssen oder Feldklemmen des Anschlussmodulteils anliegen. Dieses Abziehen kann unter anderem zu Fehlern auf dem Bus führen. Des Weiteren kann es zu Fehlern bei einem angeschlossenen Peripheriegeräte (wie beispielsweise einem Aktor) führen, insbesondere wenn die Elektronik des Elektronikmodulteils grade hochläuft bzw. anläuft. Beispielsweise im Falle eines angeschlossenen bzw. angesteuerten Aktors, von dessen Bewegung Gefahr für Personen ausgeht, kann ein solches Abziehen des Elektronikmodulteils mit aufgesetztem Anschlussmodulteil von dem Busmodulteil daher sicherheitskritisch sein. Des Weiteren können (insbesondere im Fehlerfall) hohe Spannungen an dem Elektronikmodulteil anliegen, so dass der Benutzer, der das Elektronikmodulteil mit aufgesetztem Anschlussmodulteil von dem Busmodulteil abzieht, durch hohe Spannungen verletzt werden kann.

EP 0 909 122 A2 offenbart ein Modul für eine Steuerungsvorrichtung, bei der ein erstes Modulteil, welches ein elektronisches Gerät und einen Busanschluss beinhaltet, mechanisch auf einer hutförmigen Tragschiene befestigt wird. Das erste Modulteil beinhaltet und kann mit einem weiteren Modulteil kombiniert werden, welches Anschlüsse für elektrische Leitungen aufweist. Das weitere Modulteil kann auf das erste Modulteil aufgesetzt und über Steckerkontakte mit dem ersten Modulteil elektrisch und mechanisch verbunden werden. In der zusammengesetzten Anordnung blockiert ein Abschnitt des weiteren Modulteils einen Rasthaken, der betätigt werden muss, um das erste Modulteil von der hutförmigen Tragschiene zu entfernen.

EP 1 524 890 A1 offenbart eine elektrische Baugruppe mit einem Elektronikmodulteil, einem Busmodulteil und einem Steckermodulteil. Das Steckermodulteil ist verschwenkbar an einer Trägerplatte befestigt, an der auch das Busmodulteil angeordnet ist. Steckermodulteil kann über das Elektronikmodul geschwenkt und mit diesem verschraubt werden, um das Elektronikmodulteil an dem Busmodulteil zu befestigen.

DE 20 2010 004 408 U1 offenbart ein aus drei Modulteilen bestehendes Modul für eine Steuerungsvorrichtung, welches sehr ähnlich zu den Modulen der eingangs beschriebenen Steuerungsvorrichtung PSSuniversal® ausgebildet ist.

DE 20 2005 015 792 U1 offenbart ein Modulsystem mit einem Terminalmodul, einem damit verbundenen Pneumatikmodul, einem lösbar mit dem Terminalmodul verbundenen Elektronikmodul und einem elektrisch betätigbaren Ventil, das mit dem Elektronikmodul elektrisch verbindbar ist. Das Elektronikmodul weist einen federbelasteten Sperrschieber auf, der das Elektronikmodul in einer Verriegelungsstellung mit dem Pneumatikmodul verriegelt. Der Sperrschieber ist in eine Lösestellung verschiebbar, wenn das Ventil von dem Elektronikmodul abgetrennt ist.

DE 198 07 710 A1 offenbart ein modulares Automatisierungsgerät mit einem Basismodul, mit einem Elektronikmodul ohne Außenkontakte und mit einem Anschlussmodul mit Außenkontakten. Das Anschlussmodul sitzt zwischen dem Basismodul und dem Elektronikmodul und kann daher nur vom Basismodul gelöst werden, nachdem das Elektronikmodul entfernt wurde.

DE 695 07 369 T2 offenbart ein weiteres modulares Automatisierungsgerät mit einem gehäuseartigen Rahmen aus einem isolierenden Material, der vertikale Seitenwände, eine horizontale obere Wand, eine horizontale untere Wand und eine vertikale hintere Wand mit Durchlässen zur Durchführung von Steckverbindern der Module aufweist. Die Seitenwände unterteilen das interne Volumen des Rahmens in modulare Abteile, in die jeweils ein Schnittstellenmodul eingebaut werden kann. Die Schnittstellenmodule besitzen jeweils einen seitlichen Verriegelungshebel, der von einer von vorne auf ein Schnittstellenmodul aufgesteckten Klemmleiste verdeckt wird.

Vor diesem Hintergrund ist eine Aufgabe der vorliegenden Erfindung, eine Steuerungsvorrichtung und ein Modul bzw. Modulteil der eingangs genannten Art anzugeben, die fehlersicherer und/oder verletzungssicherer sind.

Gemäß einem Aspekt der Erfindung wird diese Aufgabe durch eine Steuerungsvorrichtung gemäß Anspruch 1.

Die neue Steuerungsvorrichtung verwendet also einen Blockierabschnitt, der derart ausgebildet ist, dass das Sicherungselement in der ersten und zweiten zusammengesetzten Anordnung daran gehindert bzw. blockiert wird, sich in die zweite Position zu bewegen, in der das erste Modulteil und das zweite Modulteil voneinander lösbar wären. Das erste Modulteil wird gesperrt oder blockiert bis das dritte Modulteil demontiert ist. Das Abnehmen oder Lösen des ersten Modulteils vom zweiten Modulteil ist nur möglich, wenn das dritte Modulteil demontiert ist.

Insgesamt ermöglichen die neue Steuerungsvorrichtung und das neue Modul bzw. Modulteil daher eine fehlersicherere und/oder verletzungssichere Anordnung. Die oben genannte Aufgabe ist daher vollständig gelöst.

In einer ersten Ausgestaltung umfasst der Blockierabschnitt einen Vorsprung oder Balken, der den Sicherungsbetätigungsabschnitt kontaktiert, insbesondere in der ersten Position.

In dieser Ausgestaltung wird ein Blockieren durch einfaches Ausbilden eines Vorsprungs oder Balkens bereitgestellt. Demnach wird ein Blockieren auf einfache und daher kostengünstige Art und Weise durch ein entsprechendes Ausbilden des Gehäuses des dritten Modulteils bereitgestellt.

In einer zweiten Ausgestaltung weist das dritte Modulteil ein Schwenkhalterungselement auf, an dem das erste Modulteil lösbar gehalten werden kann. Das Schwenkhalterungselement des dritten Modulteils definiert einen Schwenkpunkt mit einer Schwenkachse, so dass das erste Modulteil und das dritte Modulteil durch eine Schwenkbewegung entlang einer definierten Bewegungsbahn in die zweite zusammengesetzte Anordnung zusammengesetzt werden können.

In dieser Ausgestaltung wird eine schwenkbare Verbindung zwischen dem ersten Modulteil und dem dritten Modulteil bereitgestellt. Das erste und dritte Modulteil können so durch eine einfache Schwenkbewegung um einen fest definierten Schwenkpunkt sicher und zuverlässig zusammengesetzt werden.

In einer weiteren Ausgestaltung ist der Blockierabschnitt zumindest ein Teil des Schwenkhalterungselements.

In dieser Ausgestaltung wird das Schwenkhalterungselement nicht nur zum Definieren des Schwenkpunktes genutzt, sondern auch gleichzeitig als Blockierabschnitt zum Blockieren des ersten Modulteils. Das Schwenkhalterungselement hat daher eine Doppelfunktion.

In einer weiteren Ausgestaltung weist das erste Modulteil ein Schwenkhalterungselement auf, an dem das zweite Modulteil lösbar gehalten werden kann. Das Schwenkhalterungselement des ersten Modulteils definiert einen Schwenkpunkt mit einer Schwenkachse, so dass das erste Modulteil und das zweite Modulteil durch eine Schwenkbewegung entlang einer definierten Bewegungsbahn in die erste zusammengesetzte Anordnung zusammengesetzt werden können.

In dieser Ausgestaltung wird eine schwenkbare Verbindung zwischen dem ersten Modulteil und dem zweiten Modulteil bereitgestellt. Das erste und zweite Modulteil können so durch eine einfache Schwenkbewegung um einen fest definierten Schwenkpunkt sicher und zuverlässig zusammengesetzt werden. Insbesondere in Kombination mit der zweiten Ausgestaltung wird somit eine doppelte schwenkbare Verbindung bereitgestellt.

In einer weiteren Ausgestaltung sind das Schwenkhaltungselement des ersten Modulteils und das Schwenkhalterungselement des dritten Modulteils an sich einander gegenüberliegenden Seiten des Moduls angeordnet.

In dieser Ausgestaltung kann ein optimales Auf- und Abschwenken der Modulteile erreicht werden. Insbesondere kann das dritte Modulteil in eine erste Richtung (z.B. nach rechts) abschwenkbar und das erste Modulteils in eine zweite, der ersten entgegengesetzte Richtung (z.B. nach links) abschwenkbar sein.

In einer weiteren Ausgestaltung ist der Sicherungseingriffsabschnitt ein Vorsprung oder Balken, der in der ersten Position in sicherndem Eingriff mit einer Aussparung des zweiten Modulteils ist.

In dieser Ausgestaltung wird eine einfache und daher kostengünstige Bauweise zum Sichern des ersten Modulteils an dem zweiten Modulteil bereitgestellt. Es kann so ein Schnappverschluss zum Sichern des ersten Modulteils an dem zweiten Modulteil bereitgestellt werden.

In einer Ausgestaltung umfasst das Sicherungselement einen Schnappverschluss.

In einer weiteren Ausgestaltung ist das Sicherungselement ein Hebel mit einem definierten Fixpunkt.

In dieser Ausgestaltung wird eine einfache und daher kostengünstige Betätigung des Sicherungselements durch einen Hebeleffekt bereitgestellt.

In einer weiteren Ausgestaltung ist der Hebel ein zweiseitiger Hebel mit einem ersten und einem zweiten Hebelteil bezüglich des Fixpunktes. Der Sicherungsbetätigungsabschnitt befindet sich auf dem ersten Hebelteil und der Sicherungseingriffsabschnitt befindet sich auf dem zweiten Hebelteil.

In dieser Ausgestaltung wird eine vorteilhafte Konstruktion mit kurzem Hebel bereitgestellt. Der benötigte Kraftaufwand bei Ausüben von Kraft auf den Sicherungsbetätigungsabschnitt wird dadurch verkleinert bzw. minimiert.

In einer alternativen Ausgestaltung ist der Hebel ein einseitiger Hebel.

In dieser Ausgestaltung wird eine einfache Ausgestaltung durch einen einseitigen Hebel bereitgestellt.

In einer weiteren Ausgestaltung ist der Sicherungsbetätigungsabschnitt des Hebels in einer Richtung in einer Ebene beweglich, die senkrecht zu einer durch den Fixpunkt definierten Fixpunktachse angeordnet ist. Der Sicherungsbetätigungsabschnitt ist in der ersten Position in einer ersten Winkellage in der Ebene angeordnet. Der Sicherungsbetätigungsabschnitt ist in der zweiten Position in einer anderen, zweiten Winkellage in der Ebene angeordnet.

In dieser Ausgestaltung wird die Beweglichkeit des Sicherungselements durch ein einfaches Hin- und Herbewegen und daher Verändern der Winkellage bereitgestellt.

In einer weiteren Ausgestaltung ist der Blockierabschnitt in der zweiten zusammengesetzten Anordnung bzw. Zustand zumindest teilweise in einem Bereich zwischen der ersten Winkellage und der zweiten Winkellage angeordnet.

In einer weiteren Ausgestaltung ist der Sicherungsbetätigungsabschnitt an einem Ende des Sicherungselementes angeordnet.

In einer weiteren Ausgestaltung umfasst das erste Modulteil ein Gehäuse, wobei das Sicherungselement an dem Gehäuse befestigt ist.

In dieser Ausgestaltung ist das Sicherungselement einfach von außen her zugänglich. Das erste und zweite Modulteil sind daher auf einfache Art und Weise jederzeit lösbar.

In einer weiteren Ausgestaltung weist das erste Modulteil zwei redundante Signalverarbeitungskanäle auf, um zumindest ein Eingangssignal redundant zueinander zu verarbeiten. Die zwei redundanten Signalverarbeitungskanäle können jeweils in der Lage sein, logische Signalverknüpfungen vorzunehmen, um in Abhängigkeit davon ein Signal zu erzeugen. Dieses Signal kann bevorzugt verwendet werden, um ein Schaltelement zum Abschalten der technischen Anlage anzusteuern. Das zumindest eine Eingangssignal kann ein Signal sein, das an dem externen Anschluss des dritten Modulteils anliegt. Bevorzugt verarbeiten die zwei Signalverarbeitungskanäle zwei Eingangssignale redundant zueinander. Jedes der zwei Eingangssignale kann dann ein Signal sein, das an jeweils einem externen Anschluss des dritten Modulteils anliegt.

In dieser Ausgestaltung führt das entsprechende Modul bzw. Modulteil Sicherheitsaufgaben oder Sicherheitsfunktionen aus. Insbesondere kann hier das entsprechende Modul bzw. Modulteil zum fehlersicheren (FS) Abschalten der technischen Anlage verwendet werden.

In einer weiteren Ausgestaltung weist die Steuerungsvorrichtung eine Anzahl von in einer Längsrichtung nebeneinander angeordneten Modulen auf.

In einer weiteren Ausgestaltung umfasst auch das dritte Modulteil ein Sicherungselement mit einem Sicherungseingriffsabschnitt, um das erste und dritte Modulteil in der zweiten zusammengesetzten Anordnung aneinander zu sichern.

In dieser Ausgestaltung wird nicht nur eine Sicherung des ersten und des zweiten Modulteils aneinander gewährleistet, sondern auch eine Sicherung des ersten Modulteils und des dritten Modulteils aneinander.

In einer weiteren Ausgestaltung umfasst das dritte Modulteil einen Überdehnschutz, um das Sicherungselement des dritten Modulteils gegen ein Überdehnen zu schützen. Der Überdehnschutz kann insbesondere ein Abrissschutz sein, um das Sicherungselement des dritten Modulteils gegen ein Abreißen von dem dritten Modulteil zu schützen.

In dieser Ausgestaltung ist das Sicherungselement des dritten Modulteils sowohl während des Transportes als auch beim Aufbau (Zusammensetzen des Moduls) gegen ein Überdehnen bzw. Abreißen geschützt. Der Überdehnschutz bzw. Abrissschutz kann insbesondere ein Balken sein, der vor dem Sicherungselement des dritten Modulteils angeordnet ist.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer technischen Anlage mit einem Ausführungsbeispiel der Steuerungsvorrichtung,
- Fig. 2: eine perspektivische Darstellung eines Ausführungsbeispiels der Steuervorrichtung mit mehreren nebeneinander angeordneten Modulen mit ersten Modulteilen und zweite Modulteilen,
- Fig. 3: eine perspektivische Darstellung des Ausführungsbeispiels der Steuervorrichtung nach Fig. 2 mit nur zweiten Modulteilen,
- Fig. 4: eine perspektivische Darstellung eines ersten Ausführungsbeispiels eines Moduls mit einem ersten, zweiten und dritten Modulteil in einer ersten und zweiten zusammengesetzten Anordnung,
- Fig. 4a: eine Querschnittsansicht des in Fig. 4 gezeigten Moduls,
- Fig. 5: eine perspektivische Darstellung des ersten Ausführungsbeispiels des Moduls der Fig. 4 in einem Zustand, in dem das dritte Modulteil gelöst wird,
- Fig. 5a: eine Querschnittsansicht des in Fig. 5 gezeigten Moduls,
- Fig. 6: eine perspektivische Darstellung des ersten Ausführungsbeispiels des Moduls der Fig. 4 bis 5 in einem Zustand, in dem das erste Modulteil in der ersten zusammengesetzten Anordnung lösbar ist,
- Fig. 6a: eine Querschnittsansicht des in Fig. 6 gezeigten Moduls,
- Fig. 7: eine perspektivische Darstellung des ersten Ausführungsbeispiels des Moduls der Fig. 4 bis 6 in einem Zustand, in dem das erste Modulteil gelöst wird,
- Fig. 7a: eine Querschnittsansicht des in Fig. 7 gezeigten Moduls,
- Fig. 8: eine perspektivische Darstellung eines zweiten Ausführungsbeispiels eines Moduls mit einem ersten, zweiten und dritten Modulteil in einer ersten und zweiten zusammengesetzten Anordnung,
- Fig. 8a: eine Querschnittsansicht des in Fig. 8 gezeigten Moduls,
- Fig. 8b: einen vergrößerten Bereich X der Querschnittsansicht der Fig. 8a,
- Fig. 9-11: jeweils eine perspektivische Darstellung eines weiteren Ausführungsbeispiels eines Moduls mit ersten und zweiten Modulteilen,
- Fig. 11a: eine perspektivische Ansicht des ersten Modulteils der Fig. 11,
- Fig. 12: eine perspektivische Ansicht eines Ausführungsbeispiels des zweiten Modulteils, insbesondere des zweiten Modulteils der Fig. 2 und 3,
- Fig. 13: eine Draufsicht von oben auf das zweite Modulteil der Fig. 12,
- Fig. 14: eine perspektivische Innenansicht des zweiten Modulteils der Fig. 12 und 13, und
- Fig. 14a: einen vergrößerten Bereich X der perspektivischen Innenansicht der Fig. 14.

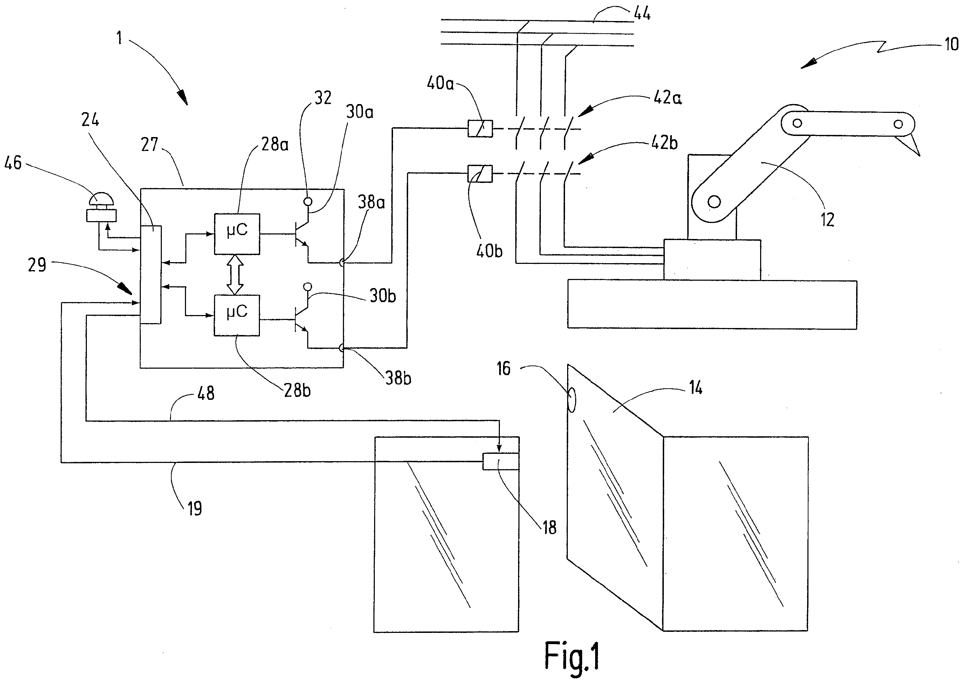

In Fig. 1 ist eine technische Anlage 10 mit einem Ausführungsbeispiel der neuen Steuerungsvorrichtung 1 zum automatisierten Steuern der technischen Anlage 10 dargestellt. In diesem Ausführungsbeispiel ist die Steuerungsvorrichtung 1 geeignet zum fehlersicheren Abschalten der Anlage 10, d.h. die Steuerungsvorrichtung 1 wird für Sicherheitsaufgaben verwendet. Die Anlage 10 beinhaltet hier beispielhaft einen Roboter 12, von dessen Bewegungen im Arbeitsbetrieb eine Gefahr für Personen ausgeht, die sich im Arbeitsbereich des Roboters 12 aufhalten. Aus diesem Grund ist der Arbeitsbereich des Roboters 12 mit einem Schutzzaun mit einer Schutztür 14 abgesichert. Die Schutztür 14 ermöglicht den Zugang in den Arbeitsbereich des Roboters 12, beispielsweise für Wartungsarbeiten oder für Einrichtarbeiten. Im normalen Arbeitsbetrieb darf der Roboter 12 jedoch nur arbeiten, wenn die Schutztür 14 geschlossen ist. Sobald die Schutztür 14 geöffnet wird, muss der Roboter 12 abgeschaltet werden oder auf andere Weise in einen sicheren Zustand gebracht werden.

Um den geschlossenen Zustand der Schutztür 14 zu detektieren, ist an der Schutztür 14 ein Schutztürschalter mit einem Türteil 16 und einem Rahmenteil 18 angebracht. Das Rahmenteil 18 erzeugt auf einer Leitung 20 ein Schutztürsignal, das über die Leitung 20 der neuen Steuerungsvorrichtung 1 zugeführt ist.

Die Steuerungsvorrichtung 1 besitzt in diesem Ausführungsbeispiel einen E/A-Teil 24 mit einer Vielzahl von Anschlüssen (bzw. externen oder Geräteanschlüssen) 29. In einigen Ausführungsbeispielen sind die Anschlüsse 29 Anschlussklemmen oder Feldklemmen, die an einer Gehäuseseite des Gehäuses 27 der Steuerungsvorrichtung 1 angeordnet sind, beispielsweise an einem Anschlussmodulteil, wie im Folgenden erklärt werden wird. Beispielsweise kann es sich um Federzugklemmen oder um Schraubklemmen handeln. In anderen Ausführungsbeispielen können die Anschlüsse Stecker oder Buchsen sein, die mehrere Kontaktelemente (Pins) beinhalten, wobei jeweils ein Pin einen Anschluss bildet. Häufig werden M8-Buchsen mit fünf Kontaktpins für den Anschluss von Meldegeräten oder anderen Sensoren auf Feldebene verwendet. Dementsprechend können Ausführungsbeispiele der neuen Steuerungsvorrichtung Feldgeräte sein oder umfassen, die außerhalb eines Schaltschranks in räumlicher Nähe zu dem Roboter 12 angeordnet sind.

Die Steuerungsvorrichtung 1 besitzt in diesem Ausführungsbeispiel zwei redundante Signalverarbeitungskanäle. Beispielhaft sind hier zwei Mikrokontroller 28a, 28b dargestellt, die jeweils mit dem E/A-Teil 24 verbunden sind. Die Mikrokontroller 28a, 28b verarbeiten hier redundant zueinander die Eingangssignale, die das Steuerungsvorrichtung 1 an den Geräteanschlüssen des E/A-Teils 24 aufnimmt, und sie vergleichen ihre Ergebnisse, was mit einem Pfeil 29 dargestellt ist. Anstelle von zwei Mikrokontrollern 28a, 28b können Mikroprozessoren, ASICs, FPGAs und/oder andere Signalverarbeitungsschaltkreise verwendet sein. Bevorzugt besitzen Ausführungsbeispiele der Steuerungsvorrichtung 1 zumindest zwei zueinander redundante Signalverarbeitungskanäle, die jeweils in der Lage sind, logische Signalverknüpfungen vorzunehmen, um in Abhängigkeit davon ein Signal zu erzeugen. Dieses Signal wird dann verwendet, um ein Schaltelement zum Abschalten der technischen Anlage 10 bzw. des Roboters 12 anzusteuern. Eine solche Steuerungsvorrichtung 1 kann dann zum fehlersicheren (FS) Abschalten der Anlage 10, hier des Roboters 12, verwendet werden.

In dem hier dargestellten Fall besitzt die Steuerungsvorrichtung 1 zwei redundante Schaltelemente 30a, 30b. Jedes dieser beiden Schaltelemente ist in der Lage, ein hohes Spannungspotential 32 zu einem Geräteanschluss 38a, 38b der Steuervorrichtung 1 durchzuschalten, um einen Stromfluss zu einem Schütz 40a, 40b zu ermöglichen, oder diesen Stromfluss zu unterbrechen. Damit kann jedes der Schaltelemente 30 einen Aktor, wie einen Schütz oder ein Magnetventil, abschalten.

Die Schütze 40a, 40b besitzen jeweils Arbeitskontakte 42a, 42b. Die Arbeitskontakte 42a, 42b sind hier in Reihe zueinander in einen Stromversorgungspfad von einer Stromversorgung 44 zu dem Roboter 12 angeordnet. Sobald die Steuervorrichtung 1 die Schütze 40a, 40b abschaltet, fallen die Kontakte 42 ab und die Stromversorgung für den Roboter 12 wird abgeschaltet. Den einschlägigen Fachleuten ist klar, dass eine solche "radikale" Abschaltung hier beispielhaft beschrieben ist. Abweichend hiervon können bei einer Sicherheitsanforderung lediglich Teile des Roboters 12 abgeschaltet werden, wie etwa die gefährlichen Antriebe, während andere Teile des Roboters 12 funktionsbereit bleiben. Auch ein verzögertes Abschalten ist denkbar, damit der Roboter 12 ggf. vor dem Abschalten der Antriebe kontrolliert abgebremst werden kann.

Die Steuervorrichtung 1 steuert die Schaltelemente 30a, 30b hier in Abhängigkeit von dem Signal des Schutztürschalters auf der Leitung 19 und in Abhängigkeit von einem weiteren Eingangssignal von einem Not-Aus-Taster 46 an. Auch der Not-Aus-Taster 46 ist über Leitungen mit Geräteanschlüssen der Steuervorrichtung 1 verbunden. Bevorzugt kann jedes der Eingangssignale redundant anliegen bzw. es können jeweils zwei Eingangs- und Ausgangsleitungen oder Anschlüsse vorgesehen sein (in Fig. 1 nicht dargestellt). In dem in Fig. 1 gezeigten Beispiel können also für den Not-Aus-Taster 46 zwei Eingangsleitungen oder Eingänge vorgesehen sein, die jeweils ein Eingangssignal von dem Not-Aus- Taster 46 liefern. Ähnliches gilt für das Signal des Schutztürschalters.

In einigen Ausführungsbeispielen erzeugt die Steuervorrichtung 1 Ausgangssignale, die den einzelnen Meldegeräten zugeführt sind. Beispielhaft ist ein solches Ausgangssignal über eine Leitung 48 zu dem Rahmenteil 18 des Schutztürschalters geführt. Das Rahmenteil 18 schleift das Ausgangssignal des Sicherheitsschaltgerätes 1 von der Leitung 48 auf die Leitung 19, wenn sich das Türteil 16 in der Nähe des Rahmenteils 18 befindet, das heißt wenn die Schutztür 14 geschlossen ist. Daher kann die Steuervorrichtung 1 den Schutztürschalter mit Hilfe des Ausgangssignals auf der Leitung 48 und mit Hilfe des Eingangssignals auf der Leitung 19 überwachen. In vergleichbarer Weise überwacht die Steuervorrichtung 1 hier den Not-Aus-Taster 46.

Abweichend von der Darstellung in Fig. 1 werden in der Praxis häufig zwei redundante Ausgangssignale der Steuervorrichtung 1 verwendet, die jeweils über eine separate Signalleitung zu einem Meldegerät geführt sind und über dieses Meldegerät zurück zur Steuervorrichtung 1 geschleift sind. Beispielhaft für eine solche Realisierung sei auf DE 10 2004 020 995 A1 verwiesen, die hinsichtlich der Details einer solchen redundanten Überwachung eines Meldegerätes durch Bezugnahme aufgenommen ist. Auch der Not-Aus-Taster 46 wird in der Praxis häufig mit redundanten Eingangs- und Ausgangsleitungen überwacht, wie oben erwähnt.

In dem in Fig. 1 dargestellten Ausführungsbeispiel der Steuerungsvorrichtung 1 wird die Steuerungsvorrichtung für Sicherheitsaufgaben verwendet, insbesondere zum fehlersicheren (FS) Abschalten einer Anlage. Die Steuerungsvorrichtung 1 kann jedoch auch für nicht-sicherheitsgerichtete Aufgaben bzw. Standardaufgaben (ST) verwendet werden.

Die Steuerungsvorrichtung 1 kann insbesondere eine programmierbare Steuerungsvorrichtung für eine programmierbare Steuerung der technischen Anlage sein. Alternativ kann die Steuerungsvorrichtung 1 auch eine konfigurierbare Steuerungsvorrichtung sein. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Die Steuervorrichtung 1 kann zumindest einen Bus umfassen, insbesondere einen Kommunikationsbus und/oder Versorgungsspannungsbus. Beispielsweise kann die Steuerungsvorrichtung 1 eine dezentrale Steuerungsvorrichtung sein, deren Komponenten über einen Bus miteinander verbunden sind. Die Steuerungsvorrichtung kann insbesondere ein Kopfmodul umfassen zur Koordination des Datenverkehrs auf dem (Kommunikations-)Bus. Bei einer Steuerungsvorrichtung 1 für Sicherheitsaufgaben kann der (Kommunikations-)Bus beispielsweise ein fehlersicherer Bus wie SafetyBUS p oder PROFINET sein. Bei einer Steuerungsvorrichtung 1 für Standardaufgaben kann der Bus beispielsweise ein Standardfeldbus wie CANOpen oder DeviceNet oder Ähnliches sein.

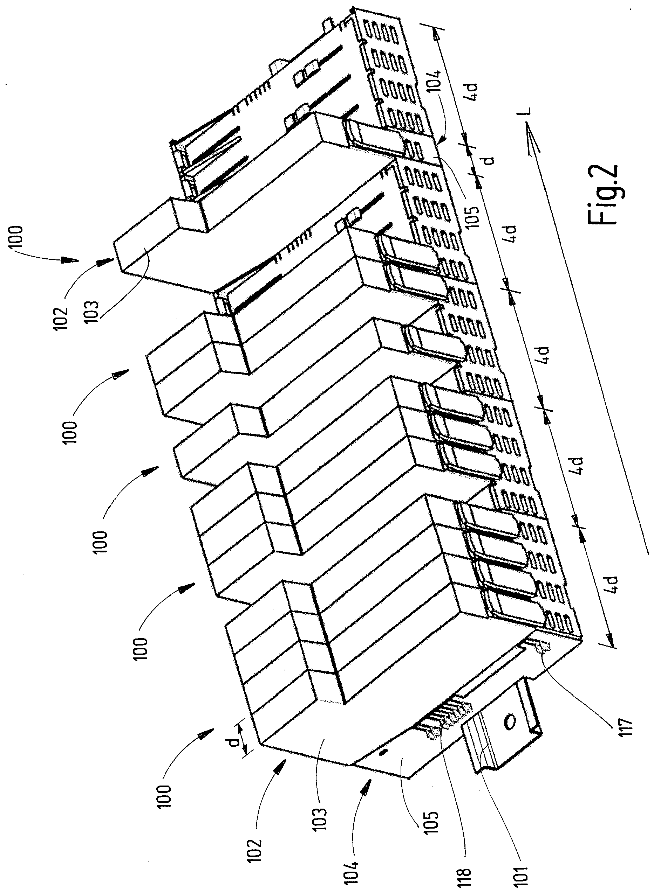

Die Steuerungsvorrichtung 1 ist insbesondere eine modulare Steuerungsvorrichtung mit zumindest einem Modul. Fig. 2 zeigt eine perspektivische Darstellung eines Ausführungsbeispiels der modularen Steuerungsvorrichtung mit mehreren nebeneinander angeordneten Modulen 100 mit ersten Modulteilen 102 und zweiten Modulteilen 104. Dritte Modulteile 106 sind in Fig. 2 nicht dargestellt. Das erste Modulteil 102 umfasst ein Gehäuse 103. Das zweite Modulteil 104 umfasst ein Gehäuse 105. Das zweite Modulteil 104 umfasst zumindest einen Busanschluss 117, 118. Das zweite Modulteil 104 wird daher im Folgenden auch Busmodulteil genannt.

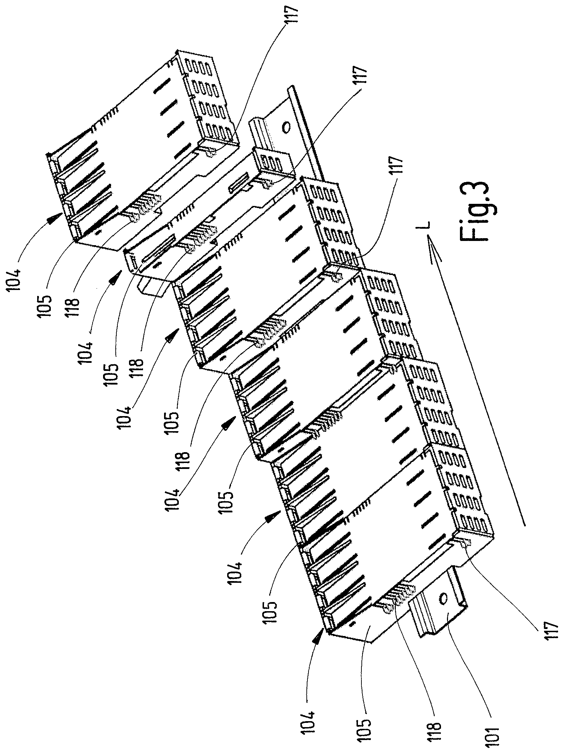

Fig. 3 zeigt eine perspektivische Darstellung des Ausführungsbeispiels der Steuervorrichtung nach Fig. 2 mit nur den zweiten Modulteilen (Busmodulteile) 104. Die zweiten Modulteile (Busmodulteile) 104 bzw. die Module 100 sind in einer Längsrichtung L nebeneinander angeordnet. Die zweiten Modulteile 104 bzw. die Module 100 werden, wie in Fig. 3 gezeigt, auf einer Führungsschiene 101 montiert. Das zweite Modulteil (Busmodulteil) 104 weist einen Busanschluss 117 für einen Versorgungsspannungsbus und einen Busanschluss 118 für einen Kommunikationsbus auf. Das zweite Modulteil (Busmodulteil) 104 umfasst einen ersten elektrischen Busanschluss 117, 118 an einer ersten Seite des Gehäuses 105 zur elektrischen Verbindung mit einem in Längsrichtung L danebenliegenden Nachbarmodulteil (in Fig. 2 und 3 einem rechts danebenliegenden Nachbarmodulteil). Das zweite Modulteil (Busmodulteil) 104 umfasst weiterhin einen zweiten elektrischen Busanschluss 117', 118' (in Fig. 3 nicht zu sehen) an einer zweiten, der ersten Seite gegenüberliegenden Seite des Gehäuses 105 zur elektrischen Verbindung mit einem in Längsrichtung L danebenliegenden anderen Nachbarmodulteil (in Fig. 2 und Fig. 3 einem links danebenliegenden Nachbarmodulteil). Insbesondere kann der zweite elektrische Busanschluss 117', 118' mit dem entsprechenden ersten elektrischen Busanschluss 117, 118 des anderen Nachbarmodulteils verbunden werden. Auf diese Weise wird der Versorgungsspannungsbus und der Kommunikationsbus über die zweiten Modulteile (Busmodulteile) 104 hinweg durchgeschaltet.

Die Steuerungsvorrichtung 1 kann weiterhin ein Kopfmodul (in Fig. 2 und Fig. 3 nicht dargestellt) umfassen, das Schnittstellen und ein Verarbeitungsteil umfasst, insbesondere zur Koordination des Datenverkehrs auf dem (Kommunikations-)Bus wie zuvor beschrieben. Das Kopfmodul kann dann ebenfalls auf der Führungsschiene 101 montiert sein bzw. werden. Das Kopfmodul kann in Längsrichtung L neben den zweiten Modulteilen (Busmodulteile) 104 bzw. Modulen 100, wie oben beschrieben, angeordnet sein. In Fig. 2 und Fig. 3 kann das Kopfmodul beispielsweise links neben dem in Längsrichtung L ersten Modul 100 angeordnet sein und über den ersten Busanschluss 117, 118 mit den Modulen verbunden sein. Jedes Modul 100, bzw. das entsprechende erste Modulteil (Elektronikmodulteil) 102, kann ein E/A(Ein/Ausgabe)-Modul bzw. Modulteil sein. Das E/A-Modul bzw. Modulteil kann ein fehlersicheres Modul (Fail-safe bzw. FS) oder ein nicht-fehlersicheres Standardmodul (ST) sein. Beispielhaft für eine solche Realisierung sei auf WO 2005/003869 A1 verwiesen.

Wie in Fig. 3 ersichtlich wird durch die nebeneinanderliegenden zweiten Modulteile (Busmodulteile) 104 eine sogenannte Backplane bereitgestellt. Auf dieser Backplane können dann erste Modulteile 102 frei wählbar angeordnet werden. Die Backplane bildet hier insbesondere eine im Wesentlichen ebene Fläche. Eine fortlaufende Aneinanderreihung von ersten Modulteilen (Elektronikmodulteilen) 102 auf der Backplane ist nicht zwingend notwendig. Wie in Fig. 2 zu sehen, muss auf einem bestimmten zweiten Modulteil (Busmodulteil) 104, bzw. einem bestimmten Abschnitt einer Grundbreite d eines zweiten Busmodulteils (Busmodulteil) 104, nicht zwingend ein erstes Modulteil (Elektronikmodulteil) 102 angeordnet sein.

Wieder Bezug nehmend auf Fig. 2 kann auf ein jeweils zweites Modulteil 104 (Busmodulteil) zumindest ein erstes Modulteil 102 aufgesteckt werden. Bevorzugt umfasst das erste Modulteil 102 eine elektrische Steuerungsschaltung zum automatisierten Steuern, beispielsweise mit einer oder mehreren Verarbeitungseinheiten, wie in Bezug auf Fig. 1 erklärt. Das erste Modulteil 102 wird im Folgenden auch Elektronikmodulteil genannt. Das erste Modulteil 102 (Elektronikmodulteil) und das zweite Modulteil 104 (Busmodulteil) können mechanisch und elektrisch in eine erste zusammengesetzte Anordnung zusammengesetzt werden, wie in Fig. 2 gezeigt. Durch diesen modularen Aufbau der Steuerungsvorrichtung 1 ist die Reaktion auf Änderungen und Anpassungen ohne größeren Aufwand möglich.

In dem in Fig. 2 und Fig. 3 dargestellten Ausführungsbeispiel wird das zweite Modulteil (Busmodulteil) 104 in mehreren Breitenformen bereitgestellt. Das erste Modulteil (Elektronikmodulteil) 102 hat eine Grundbreite d in Längsrichtung L. Einige der zweiten Modulteile 104 (Busmodulteil) haben jeweils eine Breite in Längsrichtung L, die ein ganzzahliges Vielfaches (n-faches) der Grundbreite d ist, insbesondere hier eine Breite, die ein Vierfaches der Grundbreite d ist (in Fig. 2 und Fig. 3 mit 4d bezeichnet). In diesem Fall ist das ganzzahlige Vielfache also ein gradzahliges Vielfaches, nämlich 4. Die Vierfache Grundbreite hat sich als besonders geeignet erwiesen für das Zusammensetzen einer größeren Backplane. Es kann jedoch auch jedes andere geeignete ganzzahlige Vielfache gewählt werden.

Wie in dem Ausführungsbeispiel der Fig. 2 und Fig. 3 zu sehen, hat ein anderes zweites Modulteil (Busmodulteil) 104 eine Breite, die der Grundbreite d entspricht. Das zweite Modulteil (Busmodulteil) wird also in zwei Breitenformen mit unterschiedlichen Breiten bereitgestellt. In einer ersten Breitenform mit der Grundbreite d und in einer zweiten Breitenform mit einer Breite 4d, die ein Vierfaches der Grundbreite d ist. Die Backplane kann so durch Anordnen nebeneinanderliegender zweiter Modulteile (Busmodulteile) der ersten und/oder zweiten Breitenform frei wählbar zusammengestellt werden. Durch Vorsehen von zweiten Modulteilen (Busmodulteile) 104 einer Breite, die ein ganzzahliges Vielfaches der Grundbreite d ist, werden weniger zweite Modulteile 104 benötigt, verglichen mit der Verwendung von ausschließlich zweiten Modulteilen 104 der Grundbreite d.

In dem in Fig. 2 dargestellten Ausführungsbeispiel haben alle ersten Modulteilen (Elektronikmodulteile) 102 die Grundbreite d in Längsrichtung L. Es können jedoch auch andere erste Modulteile 102 bereitgestellt werden, die eine Breite in Längsrichtung L haben, die ein ganzzahliges Vielfaches der Grundbreite d (m-faches) ist, insbesondere ein gradzahliges Vielfaches (z.B. 2-faches). Beispielsweise können andere erste Modulteile eine Breite in Längsrichtung aufweisen, die ein Zweifaches der Grundbreite d ist. Das erste Modulteil (Elektronikmodulteil) wird so in zwei Breitenformen mit zwei unterschiedlichen Breiten bereitgestellt. In einer ersten Breitenform mit der Grundbreite d und in einer zweiten Breitenform mit einer Breite, die ein ganzzahliges Vielfaches (m-faches) der Grundbreite d ist. Das erste Modulteil in der zweiten Breitenform kann dann über eine Trennstelle zwischen zwei nebeneinanderliegenden zweiten Modulteilen (Busmodulteilen) 104 hinweg angeordnet werden.

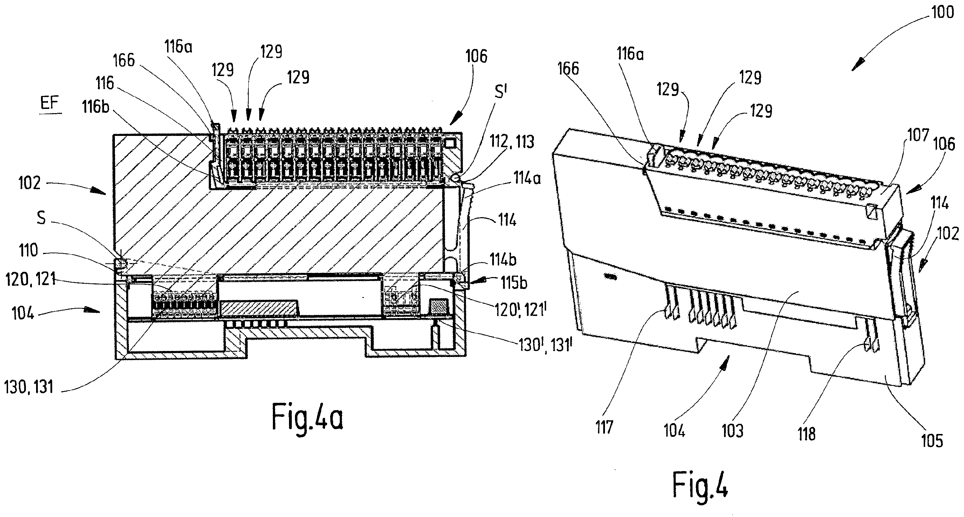

Fig. 4 zeigt eine perspektivische Darstellung eines ersten Ausführungsbeispiels eines Moduls 100, das ein erstes Modulteil 102, ein zweites Modulteil 104, und ein drittes Modulteil 106 umfasst. Fig. 4a zeigt eine entsprechende Querschnittsansicht des in Fig. 4 gezeigten Moduls 100. Das erste bzw. zweite Modulteil 102, 104 in diesem Ausführungsbeispiel kann insbesondere ein erstes bzw. zweites Modulteil sein, wie in Bezug auf Fig. 2 und Fig. 3 erläutert. Das dritte Modulteil 106 umfasst ein Gehäuse 107. Das dritte Modulteil 106 umfasst weiterhin zumindest einen externen Anschluss 129 zum Anlegen eines Signals oder einer Spannung von außen. Die Anschlüsse 129 können insbesondere die in Bezug auf Fig. 1 beschriebenen Anschlüsse 29 sein oder umfassen. In Fig. 4 und Fig. 4a sind eine Mehrzahl von externen Anschlüssen 129 dargestellt, die nebeneinanderliegend am Gehäuse 107 des dritten Modulteils angeordnet sind. Das dritte Modulteil 106 wird daher im Folgenden auch Anschlussmodulteil genannt. In dem dargestellten Ausführungsbeispiel umfasst das dritte Modulteil 106 sechzehn externe Anschlüsse 129, die in einer einzigen Reihe angeordnet sind (16-polig und einreihig). Es sollte jedoch verstanden werden, dass jede andere geeignete Anzahl und Anordnung von externen Anschlüssen vorgesehen sein kann. Ein externer Anschluss kann ein Ausgang zum Übermitteln eines Ausgangssignals (beispielsweise an einen Aktor) oder ein Eingang zum Aufnehmen eines Eingangssignals (beispielsweise von einem Sensor) sein.

Wie bereits in Bezug auf Fig. 2 erläutert, können das erste Modulteil 102 und das zweite Modulteil 104 mechanisch und elektrisch in eine erste zusammengesetzte Anordnung zusammengesetzt werden. Auch das erste Modulteil 102 und das dritte Modulteil 106 können mechanisch und elektrisch in einer zweiten zusammengesetzten Anordnung zusammengesetzt werden. Fig. 4 und Fig. 4a zeigen die Modulteile in der ersten und zweiten zusammengesetzten Anordnung.

Das mechanische Zusammensetzen der Modulteile wird nun im Folgenden detaillierter beschrieben mit Bezug auf Fig. 4a. Wie in Fig. 4a ersichtlich, weist das dritte Modulteil (Anschlussmodulteil) 106 ein Schwenkhalterungselement 112 auf, an dem das erste Modulteil (Elektronikmodulteil) 104 lösbar gehalten werden kann bzw. wird. Das Schwenkhalterungselement 112 definiert so einen Schwenkpunkt S' mit einer Schwenkachse A'. Auf diese Weise können das erste Modulteil 102 und das dritte Modulteil 106 durch eine Schwenkbewegung entlang einer definierten Bewegungsbahn in die zweite zusammengesetzte Anordnung mechanisch zusammengesetzt werden. Wie in Fig. 4a ersichtlich, umfasst auch das erste Modulteil (Elektronikmodulteil) 102 ein Schwenkhalterungselement 110, an dem das zweite Modulteil 104 (Busmodulteil) lösbar gehalten werden kann bzw. wird. Das Schwenkhalterungselement 110 definiert so einen Schwenkpunkt S mit einer Schwenkachse A. Auf diese Weise können das erste Modulteil 102 und das zweite Modulteil 104 durch eine Schwenkbewegung entlang einer definierten Bewegungsbahn in die zweite zusammengesetzte Anordnung zusammengesetzt werden. In dem in Fig. 4a dargestellten Ausführungsbeispiel umfasst das Schwenkhalterungselement 110, 112 jeweils einen Vorsprung (z.B. gekrümmter Vorsprung, Haken oder ähnliches), der in eine Aussparung des entsprechend anderen Modulteils eingreift. Es wird so eine schwenkbare Verbindung bereitgestellt. Die Modulteile können so durch eine einfache Schwenkbewegung um einen fest definierten Schwenkpunkt sicher und zuverlässig zusammengesetzt werden. In dem dargestellten Ausführungsbeispiel sind das Schwenkhaltungselement 110 des ersten Modulteils 102 und das Schwenkhalterungselement 112 des dritten Modulteils an sich einander gegenüberliegenden Seiten des Moduls 100 angeordnet. Somit ist in das dritte Modulteil 106 in eine erste Richtung (nach rechts in Fig. 4a) abschwenkbar und das erste Modulteils 102 ist in eine zweite, der ersten entgegengesetzte Richtung (nach links in Fig. 4a) abschwenkbar.

Das elektrische Zusammensetzen der Modulteile wird nun im Folgenden detaillierter beschrieben mit Bezug auf Fig. 4a. Das erste Modulteil (Elektronikmodulteil) 102 umfasst zumindest einen elektrischen Kontakt 120 und das zweite Modulteil (Busmodulteil) 104 umfasst zumindest einen ersten elektrischen Gegenkontakt 130, der in der ersten zusammengesetzten Anordnung den ersten elektrischen Kontakt 120 kontaktiert zur elektrischen Verbindung zwischen dem ersten Modulteil (Elektronikmodulteil) 102 und dem zweiten Modulteil (Busmodulteil) 104. Der erste elektrische Kontakt 120 des ersten Modulteils 102 ist eine Leiterbahn auf einer nicht-leitenden Platte, so dass eine Leiterplatte 121 gebildet wird. Der erste Gegenkontakt 130 des zweiten Modulteils 104 ist ein Kontaktelement (Pin), das in einem Stecker oder Buchse 131 angeordnet ist. In den Stecker oder die Buchse 131 kann die Leiterplatte 121 eingeführt werden. Es wird somit eine Steckverbindung gebildet. Insbesondere sind eine Mehrzahl von elektrischen Kontakten 120 und eine Mehrzahl von entsprechenden Gegenkontakten 130 vorgesehen. Die Mehrzahl von Kontakten 120 sind nebeneinanderliegend auf der Leiterplatte 121 angeordnet. Die Mehrzahl von entsprechenden Gegenkontakten 130 sind entsprechend nebeneinanderliegend in dem Stecker oder Buchse 131 angeordnet.

Wie in Fig. 4 und Fig. 4a zu sehen, bilden die Kontakte 120 und die entsprechenden Gegenkontakte 130 jeweils eine erste Gruppe. In diesem Ausführungsbeispiel dient die erste Gruppe dazu, die Spannung oder das Signal des Kommunikationsbuses, der mittels der Busanschlüsse 117 durchgeschaltet wird, von dem zweiten Modulteil (Busmodulteil) 104 auf das erste Modulteil (Elektronikmodulteil) 102 zu übertragen. Es ist weiterhin eine zweite Gruppe von Kontakten 120' auf einer entsprechenden Leiterplatte 121' vorgesehen, sowie entsprechende Gegenkontakte 130' in einem Stecker oder Buchse 131', wie bereits in Bezug auf die Kontakte 120 und Gegenkontakte 130 beschrieben. In diesem Ausführungsbeispiel dient die zweite Gruppe der Kontakte 120' bzw. Gegenkontakte 130' dazu, die Spannung des Versorgungsspannungsbuses, der mittels der Busanschlüsse 118 durchgeschaltet wird, von dem zweiten Modulteil (Busmodulteil) 104 auf das erste Modulteil (Elektronikmodulteil) 102 zu übertragen.

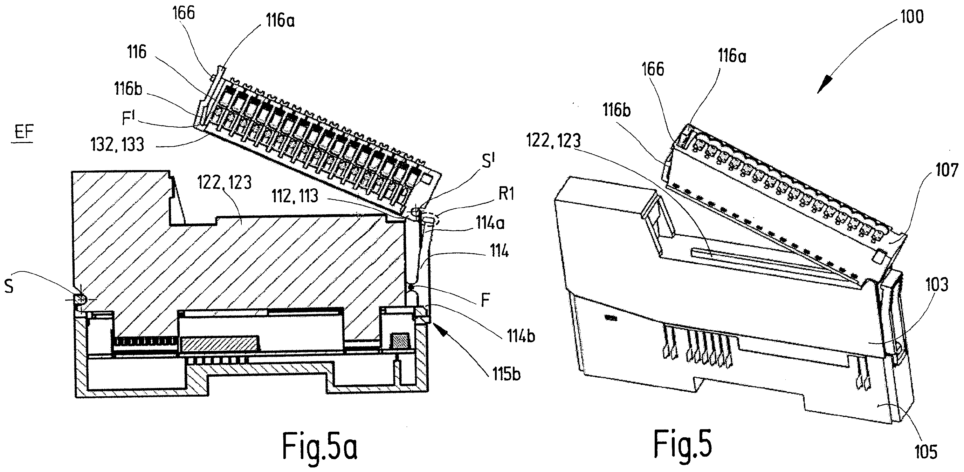

Fig. 5 zeigt eine perspektivische Darstellung des ersten Ausführungsbeispiels des Moduls 100 der Fig. 4 in einem Zustand, in dem das dritte Modulteil (Anschlussmodulteil) 106 gelöst wird. Fig. 5a zeigt eine entsprechende Querschnittsansicht des in Fig. 5 gezeigten Moduls 100. Wie in Fig. 5 und Fig. 5a zu sehen umfasst auch das dritte Modulteil (Anschlussmodulteil) 106 zumindest einen ersten elektrischen Kontakt 132 und das erste Modulteil (Elektronikmodulteil) 102 umfasst zumindest einen entsprechenden ersten elektrischen Gegenkontakt 122, der in der zweiten zusammengesetzten Anordnung den ersten elektrischen Kontakt 132 des dritten Modulteils (Busmodulteils) 106 kontaktiert zur elektrischen Verbindung zwischen dem ersten Modulteil (Elektronikmodulteil) 102 und dem dritten Modulteil (Anschlussmodulteil) 106. Der erste elektrische Gegenkontakt 122 des ersten Modulteils 102 ist eine Leiterbahn auf einer nicht-leitenden Platte, so dass eine Leiterplatte 123 gebildet wird. Der erste elektrische Kontakt 132 des dritten Modulteils 106 ist ein Kontaktelement (Pin), das in einem Stecker oder Buchse 133 angeordnet ist. In den Stecker oder die Buchse 133 kann die Leiterplatte 123 eingeführt werden. Es wird somit eine Steckverbindung gebildet. Insbesondere sind eine Mehrzahl von ersten elektrischen Kontakten 132 des dritten Modulteils 106 und eine Mehrzahl von entsprechenden ersten elektrischen Gegenkontakten 122 des ersten Modulteils 102 vorgesehen. Die Mehrzahl von ersten elektrischen Kontakten 132 des dritten Modulteils 106 sind nebeneinanderliegend in dem Stecker oder Buchse 133 angeordnet. Die Mehrzahl von entsprechenden ersten elektrischen Gegenkontakten 122 des ersten Modulteils 102 sind entsprechend nebeneinanderliegend auf der Leiterplatte 123 angeordnet.

Um das erste und zweite Modulteil 102, 104 in der ersten zusammengesetzten Anordnung aneinander zu sichern, umfasst das erste Modulteil 102 (Elektronikmodulteil) ein Sicherungselement 114 mit einem Sicherungseingriffsabschnitt 114b. Das Sicherungselement 114 bzw. der Sicherungseingriffsabschnitt 114b ist in eine erste und eine zweite Position beweglich. In der ersten Position, wie in Fig. 4 und Fig. 4a dargestellt, ist der Sicherungseingriffsabschnitt 114b mit dem zweiten Modulteil 104 (Busmodulteil) in der ersten zusammengesetzten Anordnung im sichernden Eingriff, so dass das erste Modulteil (Elektronikmodulteil) 102 und das zweite Modulteil (Busmodulteil) 104 aneinander gesichert sind. Der Sicherungseingriffsabschnitt 114b der Fig. 4a ist ein Vorsprung oder Balken, der in der ersten Position in sicherndem Eingriff mit einer Aussparung 115b des zweiten Modulteils 104 ist. Es sollte verstanden werden, dass dieses mechanische Eingreifen auf jede geeignete Art erreicht bzw. beschrieben werden kann. Beispielsweise kann auch ein Vorsprung oder Balken des zweiten Modulteils 104 in eine Aussparung des ersten Modulteils 102 bzw. des Sicherungselementes 114 eingreifen.

In der zweiten Position (in Fig. 4 und Fig. 5 nicht dargestellt) des Sicherungselementes 114, ist der Sicherungseingriffsabschnitt 114b in der ersten zusammengesetzten Anordnung derart angeordnet, dass das erste Modulteil (Elektronikmodulteil) 102 und das zweite Modulteil (Busmodulteil) 104 voneinander lösbar sind. In der zweiten Position des Sicherungselementes 114 sind das erste Modulteil (Elektronikmodulteil) 102 und das zweite Modulteil (Busmodulteil) 104 daher nicht aneinander gesichert. Das Sicherungselement 114 umfasst weiterhin einen Sicherungsbetätigungsabschnitt 114a, mittels dessen das Sicherungselement 114 in der ersten zusammengesetzten Anordnung zwischen der ersten und zweiten Position beweglich ist bei Ausüben einer Kraft auf den Sicherungsbetätigungsabschnitt 114a.

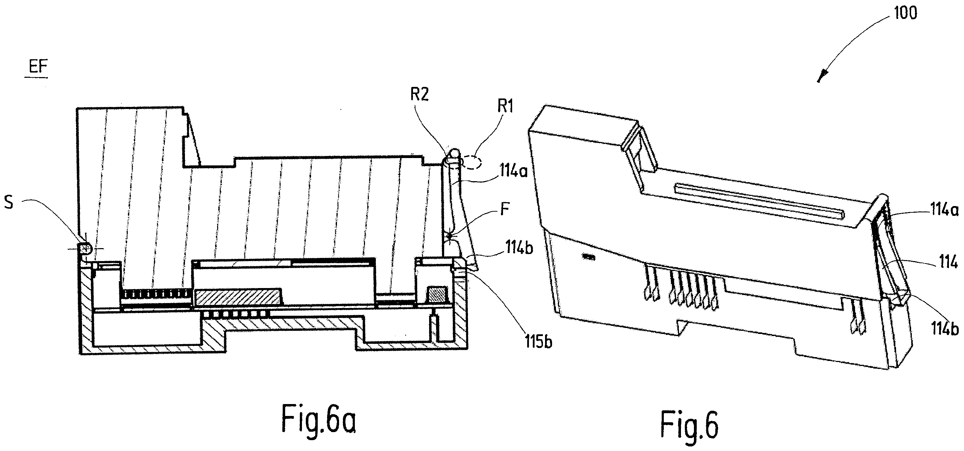

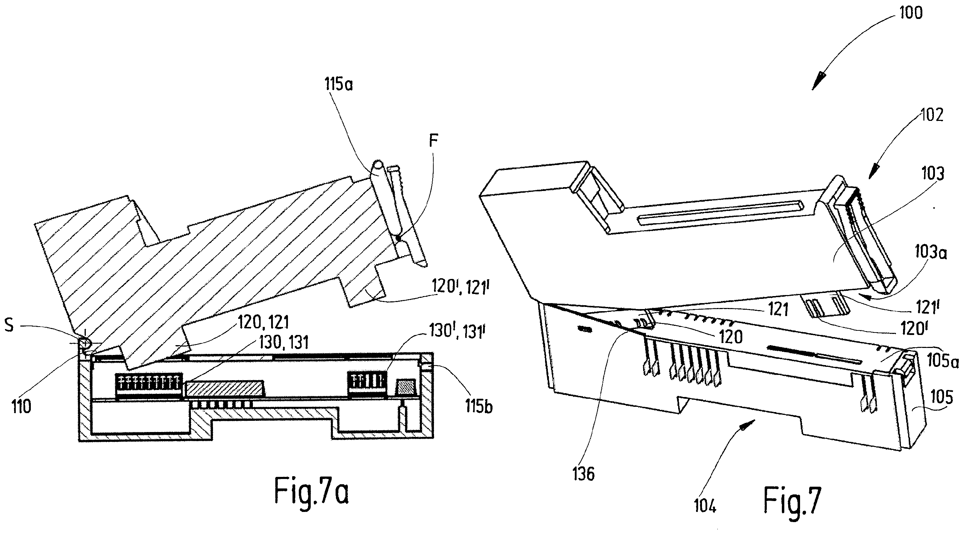

Fig. 6 zeigt eine perspektivische Darstellung des ersten Ausführungsbeispiels des Moduls 100 der Fig. 4 und der Fig. 5 in einem Zustand, in dem das erste Modulteil 102 in der ersten zusammengesetzten Anordnung lösbar ist. Fig. 6a zeigt eine entsprechende Querschnittsansicht des in Fig. 6 gezeigten Moduls 100. Fig. 7 zeige eine perspektivische Darstellung des ersten Ausführungsbeispiels des Moduls 100 der Fig. 4 bis 6 in einem Zustand, in dem das erste Modulteil 102 gelöst wird. Fig. 7a zeigt eine entsprechende Querschnittsansicht des in Fig. 7 gezeigten Moduls.

In Fig. 5 und Fig. 5a ist das Sicherungselement 114 in der ersten Position dargestellt, in der das erste Modulteil (Elektronikmodul) 102 und das zweite Modulteil (Busmodulteil) 104 aneinander gesichert sind. Der Sicherungsbetätigungsabschnitt 114a ist hier in der ersten Position in einem ersten Raumbereich R1 angeordnet. In Fig. 6 und Fig. 6a ist das Sicherungselement 114 in der zweiten Position dargestellt, in der das erste Modulteil (Elektronikmodulteil) 102 und das zweite Modulteil (Busmodulteil) 104 voneinander lösbar sind. Der Sicherungsbetätigungsabschnitt 114a ist hier in der zweiten Position in einem zweiten Raumbereich R2 angeordnet.

Das dritte Modulteil 106 weist einen Blockierabschnitt 113 auf, der in der zweiten zusammengesetzten Anordnung bzw. Zustand (Fig. 4 und Fig. 4a) zumindest teilweise in dem zweiten Raumbereich R2 angeordnet ist. In dem dargestellten Ausführungsbeispiel ist der Blockierabschnitt 113 ein Vorsprung, bzw. umfasst einen Vorsprung, der den Sicherungsbetätigungsabschnitt 114a (in der ersten Position) kontaktiert. Es wird also ein Blockierabschnitt 113 verwendet, der derart ausgebildet ist, dass das Sicherungselement 114 in der ersten und zweiten zusammengesetzten Anordnung daran gehindert bzw. blockiert wird, sich in die zweite Position zu bewegen, in der das erste Modulteil (Elektronikmodulteil) 102 und das zweite Modulteil (Busmodulteil) 104 voneinander lösbar wären. Das erste Modulteil (Elektronikmodulteil) 102 wird dadurch blockiert, bis das dritte Modulteil (Anschlussmodulteil) 106 demontiert ist. Das Abnehmen oder Lösen des ersten Modulteils (Elektronikmodulteil) 102 von dem zweiten Modulteil (Busmodulteil) 104 ist also nur möglich, wenn das dritte Modulteil (Anschlussmodulteil) 106 demontiert ist. Das erste Modulteil (Elektronikmodulteil) 102 kann daher nicht von dem zweiten Modulteil (Busmodulteil) 104 abgezogen werden, wenn das Modul noch im Einsatz ist, beispielsweise wenn Spannungen oder Signale an den externen Anschlüssen 129 des Anschlussmodulteils 106 anliegen. Es kann daher nicht zu Fehlern auf dem Bus und/oder an angeschlossenem Peripheriegerät (z.B. Aktor) kommen. Des Weiteren kann ein Benutzer nicht durch hohe Spannungen verletzt werden. In dem dargestellten Ausführungsbeispiel ist der Blockierabschnitt 113 ein Teil des Schwenkhalterungselementes 112 bzw. fällt mit diesem zusammen.

In dem dargestellten Ausführungsbeispiel der Fig. 4 bis 7 ist das Sicherungselement 114 ein Hebel mit einem definierten Fixpunkt F. Der Hebel ist hier ein zweiseitiger Hebel mit einem ersten und einem zweiten Hebelteil bezüglich des Fixpunktes F. Der Sicherungsbetätigungsabschnitt 114 befindet sich auf dem ersten Hebelteil und der Sicherungseingriffsabschnitt 114b befindet sich auf dem zweiten Hebelteil. Durch Ausüben einer Kraft auf den Sicherungsbetätigungsabschnitt 114 des Hebels ist das Sicherungselement 114 bzw. der Hebel zwischen der ersten Position (Fig. 4 und Fig. 4a, Fig. 5 und Fig. 5a) und der zweiten Position beweglich (Fig. 6 und Fig. 6a). Das Sicherungselement 114 ist an dem Gehäuse 103 des ersten Modulteils 102 befestigt bzw. integral damit ausgeformt.. Durch die Befestigung des Sicherungselements 114 (bzw. des Hebels) an dem Gehäuse 103 wird der Fixpunkt F definiert.

Es wird eine Ebene EF definiert, die senkrecht zu einer durch den Fixpunkt F des Hebels definierten Fixpunktachse FA angeordnet ist. In den Fig. 4 bis 6 verläuft die Fixpunktachse FA senkrecht zur Zeichenebene und die Ebene EF liegt in oder parallel zu der Zeichenebene. Der Sicherungsbetätigungsabschnitt 114a des Hebels ist in einer Richtung in der Ebene EF beweglich. Mit anderen Worten kann der Sicherungsbetätigungsabschnitt 114a des Hebels in Richtung der Zeichenebene hin- und herbewegt werden. In der ersten Position (Fig. 4 und Fig. 4a, Fig. 5 und Fig. 5a) ist der Sicherungsbetätigungsabschnitt 114a in einer ersten Winkellage in der Ebene EF angeordnet. Der Sicherungsbetätigungsabschnitt 114a ist dann in dem ersten Raumbereich R1 angeordnet. In der zweiten Position (Fig. 6 und Fig. 6a) ist der Sicherungsbetätigungsabschnitt 114a des Hebels in einer anderen, zweiten Winkellage in der Ebene EF angeordnet. Der Sicherungsbetätigungsabschnitt 114a ist dann im zweiten Raumbereich R2 angeordnet. Wie in Fig. 4a zu sehen, ist der Blockierabschnitt 113 in der zweiten zusammengesetzten Anordnung bzw. Zustand zumindest teilweise in einem Bereich zwischen der ersten Winkellage und der zweiten Winkellage angeordnet. Der Vorsprung bzw. Blockierabschnitt 113 erstreckt sich hier bis in den Bereich zwischen der ersten Winkellage und der zweiten Winkellage.

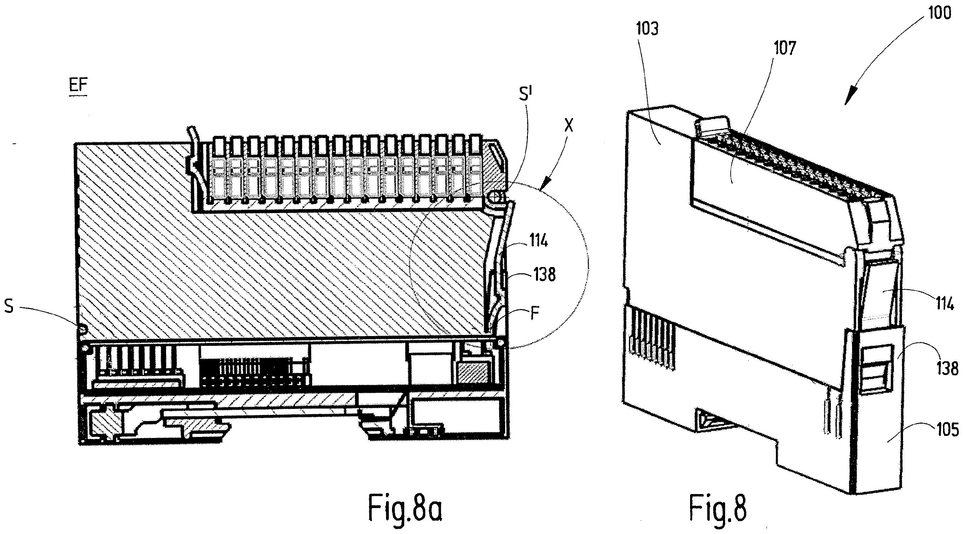

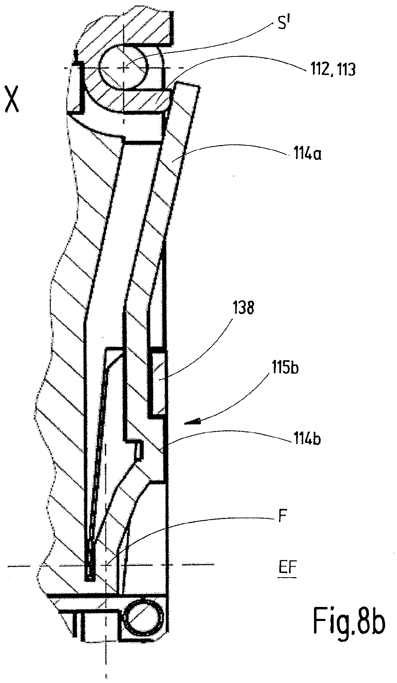

Fig. 8 zeigt eine perspektivische Darstellung eines zweiten Ausführungsbeispiels eines Moduls 100 mit einem ersten Modulteil 102, einem zweiten Modulteil 104 und einem dritten Modulteil 106 in einer ersten und zweiten zusammengesetzten Anordnung. Fig. 8a zeigt eine entsprechende Querschnittsansicht des in Fig. 8 gezeigten Moduls 100. Es wird im Wesentlichen auf die Ausführungen zu dem ersten Ausführungsbeispiel in Bezug auf Fig. 4 bis 7 verwiesen. Der Unterschied des in Fig. 8 und Fig. 8a dargestellten zweiten Ausführungsbeispiels verglichen mit dem ersten Ausführungsbeispiel der Fig. 4 bis 7 besteht jedoch darin, dass das Sicherungselement 114 hier ein einseitiger Hebel ist. Fig. 8b zeigt einen vergrößerten Bereich X der Querschnittsansicht der Fig. 8a. Das Sicherungselement 114 in Form eines einseitigen Hebels ist hier vergrößert dargestellt. Der Sicherungsbetätigungsabschnitt 114a und der Sicherungseingriffsabschnitt 114b sind beide auf dem einseitigen Hebel angeordnet. Der Sicherungseingriffsabschnitt 114b ist ein Vorsprung oder Balken, der in der ersten Position (wie in Fig. 8, Fig. 8a und Fig. 8b dargestellt) in sicherndem Eingriff mit einer Aussparung 115b des zweiten Modulteils 104 ist. Die Aussparung 115b des zweiten Modulteils 104 befindet sich in einem (in Bezug auf die Grenzfläche oder Backplane) hervorstehenden Abschnitt 138 des Gehäuses 105 des zweiten Modulteils 104.

Wie in Fig. 4, 4a, 5 und 5a zu sehen, umfasst auch das dritte Modulteil 106 (Anschlussmodulteil) ein Sicherungselement 116 mit einem Sicherungseingriffsabschnitt 116b, um das erste und dritte Modulteil 102, 106 in der zweiten zusammengesetzten Anordnung aneinander zu sichern. Das Sicherungselement 116 bzw. der Sicherungseingriffsabschnitt 116b ist in eine erste und eine zweite Position beweglich. In der ersten Position, wie in Fig. 4a dargestellt, ist der Sicherungseingriffsabschnitt 116b mit dem ersten Modulteil 102 (Elektronikmodulteil) in der zweiten zusammengesetzten Anordnung im sichernden Eingriff, so dass das erste Modulteil (Elektronikmodulteil) 102 und das dritte Modulteil (Anschlussmodulteil) 106 aneinander gesichert sind. Der Sicherungseingriffsabschnitt 116b der Fig. 4a ist ein Vorsprung oder Balken, der in der ersten Position in sicherndem Eingriff mit einer Aussparung des ersten Modulteils 102 ist. Es sollte verstanden werden, dass dieses mechanische Eingreifen auf jede geeignete Art erreicht bzw. beschrieben werden kann. Beispielsweise kann auch ein Vorsprung oder Balken des ersten Modulteils 102 in eine Aussparung des dritten Modulteils 106 bzw. des Sicherungselementes 116 eingreifen.

In der zweiten Position (in Fig. 4 und Fig. 5 nicht dargestellt) des Sicherungselementes 116 ist der Sicherungseingriffsabschnitt 116b in der zweiten zusammengesetzten Anordnung derart angeordnet, dass das erste Modulteil (Elektronikmodulteil) 102 und das dritte Modulteil (Anschlussmodulteil) 106 voneinander lösbar sind. In der zweiten Position des Sicherungselementes 116 sind das erste Modulteil (Elektronikmodulteil) 102 und das dritte Modulteil (Anschlussmodulteil) 106 daher nicht aneinander gesichert. Das Sicherungselement 116 umfasst weiterhin einen Sicherungsbetätigungsabschnitt 116a, mittels dessen das Sicherungselement 116 in der zweiten zusammengesetzten Anordnung zwischen der ersten und zweiten Position beweglich ist bei Ausüben einer Kraft auf den Sicherungsbetätigungsabschnitt 116a. In dem dargestellten Ausführungsbeispiel ist das Sicherungselement 116 ein (einseitiger) Hebel mit einem definierten Fixpunkt F'. Das Sicherungselement 116 ist an dem Gehäuse 107 des dritten Modulteils 106 befestigt bzw. integral damit ausgeformt. Durch die Befestigung des Sicherungselements 116 (bzw. des Hebels) an dem Gehäuse 107 wird der Fixpunkt F' definiert.

Des Weiteren umfasst das dritte Modulteil 106 einen Überdehnschutz (bzw. Abrissschutz) 166, um das Sicherungselement 116 gegen ein Überdehnen zu schützen (bzw. gegen en Abreißen von dem dritten Modulteil 106). Das Sicherungselement 116 (oder Hebel) ist somit sowohl während des Transportes als auch beim Aufbau (Zusammensetzen des Moduls) gegen ein Überdehnen bzw. Abreißen geschützt. Wie in Fig. 4, 4a, 5, und 5a zu sehen, ist der Überdehnschutz (bzw. Abrissschutz) 166 in diesem Ausführungsbeispiel ein Balken, der vor dem Sicherungselement 116 des dritten Modulteils 106 angeordnet ist. Durch den Balken 166 wird eine Aussparung gebildet, in der der Sicherungsbestätigungsabschnitt 116b angeordnet ist. Die Aussparung ist groß genug, um den Sicherungsbetätigungsabschnitt 116b zwischen der ersten und der zweiten Position zu bewegen.

Das mechanische Zusammensetzen bzw. Lösen des ersten Modulteils (Elektronikmodulteil) 102 und des zweiten Modulteils (Busmodulteil) 104 wird im Folgenden detaillierter beschrieben. Das Gehäuse 103 des ersten Modulteils (Elektronikmodulteil) 102 umfasst hier eine Grenzfläche 103a und das Gehäuse 105 des zweiten Modulteils (Busmodulteil) 104 umfasst eine Grenzfläche 105a (in Fig. 7 und 7a sichtbar), die sich in der ersten zusammengesetzten Anordnung bzw. Zustand (wie beispielsweise in Fig. 4 bis 6 zu sehen), derart gegenüberliegen, dass eine Grenzebene G definiert ist. In den Fig. 4a, 5a, 6a und 7a verläuft die Grenzebene G horizontal in die Zeichenebene hinein. Die Grenzflächen 105a der zweiten Modulteile (Busmodulteile) 104 bilden die Backplane. Die Leiterplatten 121, 121' des ersten Modulteils 102 können in entsprechende Aussparungen (mit Gegenkontakten 130, 130' bzw. Steckern oder Buchsen 131, 131') in dem Gehäuse 105 bzw. der Grenzfläche 105a des zweiten Modulteils eingeführt werden. Das erste Modulteil (Elektronikmodulteil) 102 und zweite Modulteil (Busmodulteil) 104 liegen daher in der ersten zusammengesetzten Anordnung bzw. Zustand plan aufeinander auf, in der Grenzebene G.

In Fig. 7 und 7a werden das erste Modulteil (Elektronikmodulteil) 102 und das zweite Modulteil (Busmodulteil) 104 durch eine Schwenkbewegung entlang einer definierten Bewegungsbahn um einen Schwenkpunkt S herum voneinander gelöst. Das Schwenkhalterungselement 110, das den Schwenkpunkt S mit der Schwenkachse A definiert, wurde bereits im Zusammenhang mit dem mechanischen Zusammensetzen der Modulteile erläutert. Wie in Fig. 7 zu sehen, umfasst das Gehäuse 105 des zweiten Modulteils (Busmodulteil) 104 eine schräge Kante 136, die vom Schwenkpunkt S aus schräg verläuft. Es ist jeweils eine schräge Kante 136 auf beiden Seiten des Gehäuses 105 vorgesehen. In dem Raum zwischen den beiden schrägen Kanten 136 wird eine Führungstasche gebildet, in der das erste Modulteil (Elektronikmodulteil) 102 beim Schwenken geführt werden kann. Es werden so die Freiheitsgrade beim Schwenken minimiert, bzw. das Spiel im Schwenkpunkt wird minimiert. Die Modulteile können so sicher und zuverlässig zusammengesetzt werden. Insbesondere kann so die Leiterplatte 120, 120' des ersten Modulteils (Elektronikmodulteil) 102 genau bzw. sauber in den entsprechenden Stecker oder Buchse 130, 130' des zweiten Modulteils (Busmodulteil) 104 eingeführt werden.

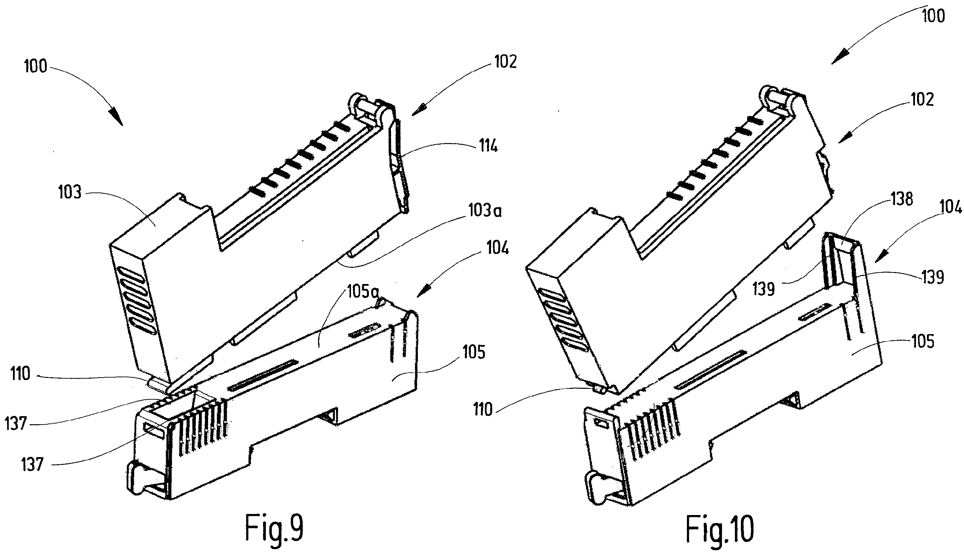

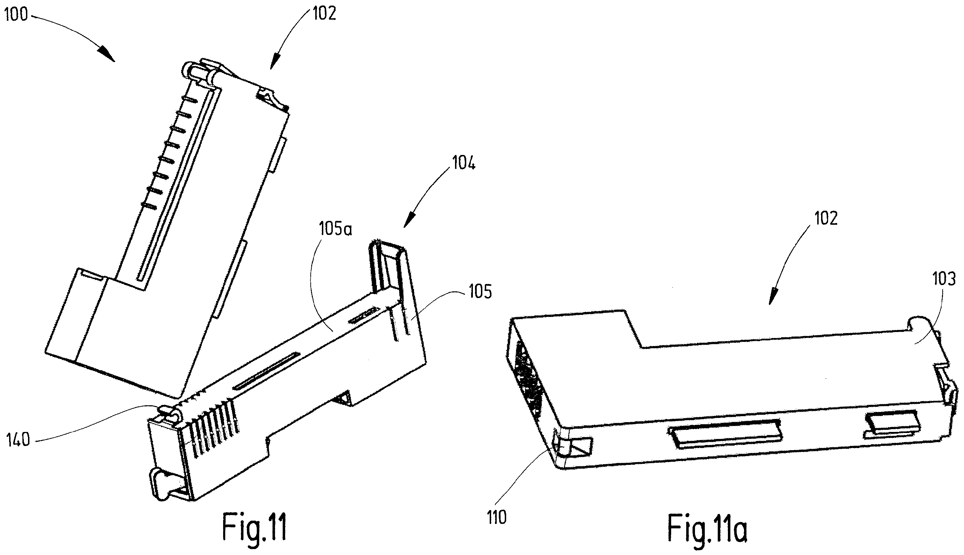

Fig. 9 bis 11 zeigen jeweils ein weiteres Ausführungsbeispiel eines Moduls 100 an einem ersten Modulteil 102 und einem zweiten Modulteil 104. Es wird im Wesentlichen auf die Ausführungen zu dem ersten und zweiten Ausführungsbeispiel in Bezug auf Fig. 4 bis 8 verwiesen. Der Unterschied des in Fig. 9 dargestellten Ausführungsbeispiels verglichen mit dem ersten Ausführungsbeispiel der Fig. 4 bis 7 besteht jedoch darin, dass die Führungstasche, in die das Schwenkhalterungselement 110 eingeführt wird, zwischen zwei geraden Kanten 137 ausgebildet ist. Die geraden Kanten liegen in der Grenzebene G bzw. in der Grenzfläche 105a. Das Schwenkhalterungselement des ersten Modulteils 102 erstreckt sich hier über die Grenzebene G bzw. die Grenzfläche 103a des ersten Modulteils 103a hinaus in Form eines Vorsprungs oder Balkens. Ein weiterer Unterschied des Ausführungsbeispiels der Fig. 9 besteht darin, dass das Sicherungselement 114 mit einer ebenen Oberfläche ausgebildet ist. Das in Fig. 10 dargestellte Ausführungsbeispiel entspricht im Wesentlichen dem in Fig. 8 gezeigten Ausführungsbeispiel. Der Unterschied des in Fig. 10 gezeigten Ausführungsbeispiels mit dem ersten Ausführungsbeispiel der Fig. 4 bis 7 besteht darin, dass das Schwenkhalterungselement 110 in Form eines Vorsprungs nicht in einer Führungstasche geführt wird. Um dennoch eine saubere Schwenkbewegung zu gewährleisten, sind hier Führungen 139 an beiden Seiten des (in Bezug auf die Grenzfläche G oder Backplane) hervorstehenden Abschnitts 138 des Gehäuses 105 vorgesehen. Der Unterschied des in Fig. 11 dargestellten Ausführungsbeispiels verglichen mit dem ersten Ausführungsbeispiel der Fig. 4 bis 7 besteht darin, dass das Schwenkhalterungselement 110 des ersten Modulteils (Elektronikmodulteil) 102 einen Balken umfasst, der in einer durch das Gehäuse 103 des zweiten Modulteils gebildeten Aussparung angeordnet ist. Genauer gesagt wird diese Aussparung durch einen auf der Grenzfläche 105a angeordneten gekrümmten Vorsprung 140 gebildet. Das Schwenkhalterungselement 110 wird hier in dem Ausführungsbeispiel der Fig. 11 nicht durch einen hervorstehenden Vorsprung gebildet wie in dem ersten Ausführungsbeispiel mit Bezug auf Fig. 4 bis 7, sondern durch einen in einer Aussparung gebildeten Balken. Dementsprechend wird in Fig. 11 die Aussparung des zweiten Modulteils (Busmodulteil) 104, in die der Balken 110 eingreift, durch den gekrümmten Vorsprung 140 gebildet.

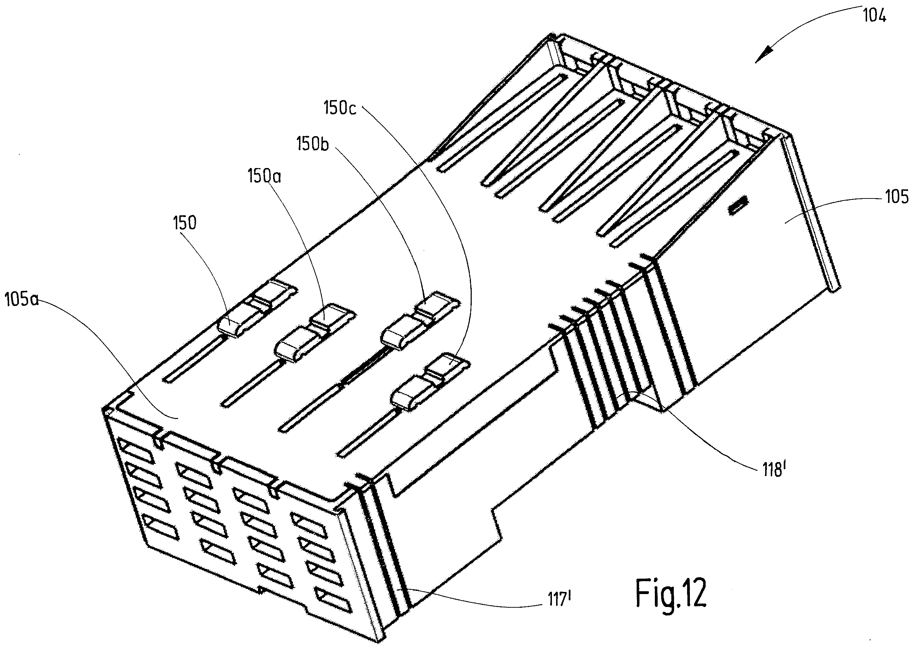

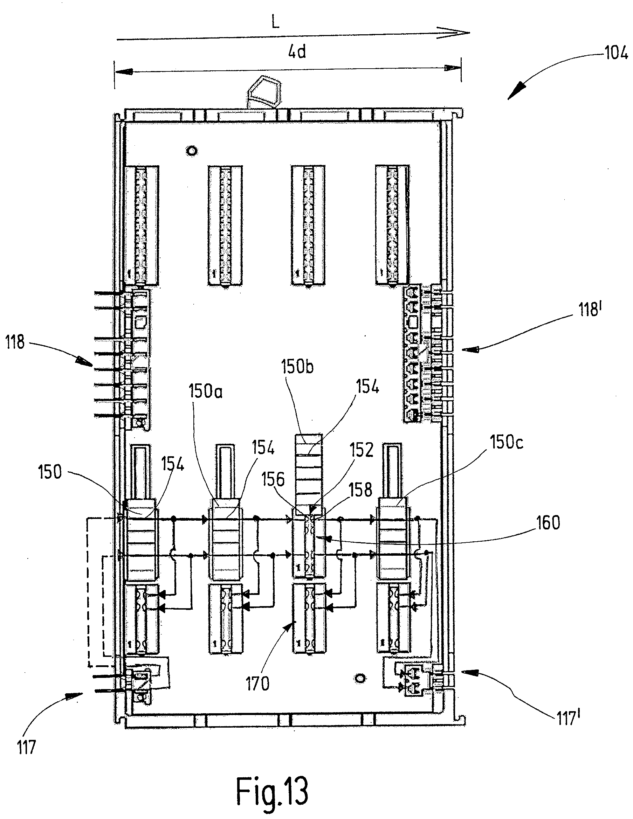

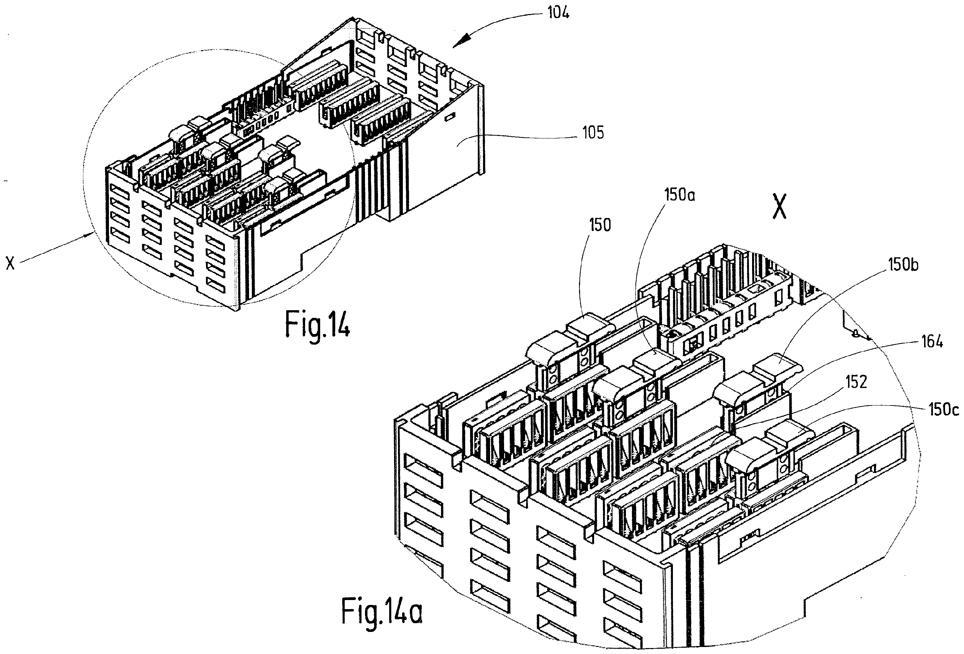

Fig. 12 zeigt eine perspektivische Darstellung eines Ausführungsbeispiels des zweiten Modulteils 104, insbesondere des zweiten Modulteils (Busmodulteil) 104 der Fig. 2 und 3. Fig. 13 zeigt eine Draufsicht von oben auf das zweite Modulteil 104 der Fig. 12. Fig. 14 zeigt eine perspektivische Innenansicht des zweiten Modulteils 104 der Fig. 12 und 13. Fig. 14a zeigt einen vergrößerten Bereich X der perspektivischen Ansicht der Fig. 14.

Das zweite Modulteil (Busmodulteil) 104 umfasst zumindest ein bewegliches Teil 150, welches in eine erste Position und eine zweite Position beweglich ist. In der ersten Position stellt das bewegliche Teil 150 eine elektrische Verbindung zwischen dem ersten Busanschluss 117 und dem zweiten Busanschluss 117' bereit. In der zweiten Position stellt das bewegliche Teil 150 eine Isolierstelle 152 zwischen dem ersten Busanschluss 117 und dem zweiten Busanschluss 117' bereit. Wie bereits in Bezug auf die vorhergehenden Figuren erläutert ist der erste und der zweite Busanschluss 117, 117' hier jeweils ein Busanschluss eines Versorgungsspannungsbusses, der eine Versorgungsspannung durchschaltet.

In dem in Fig. 12 bis 14 gezeigten Ausführungsbeispiel umfasst das zweite Modulteil (Busmodulteil) 104 eine der ganzen Zahl n entsprechende Anzahl von beweglichen Teilen 150, 150a-c. Da die Breite des zweiten Modulteils (Busmodulteil) 104 in diesem Ausführungsbeispiel das Vierfache der Grundbreite d ist, wie bereits in Bezug auf Fig. 2 und Fig. 3 erläutert, umfasst das zweite Modulteil 104 daher vier bewegliche Teile 150, 150a-c. Die beweglichen Teile 150, 150a-c sind jeweils in die erste Position und die zweite Position beweglich. Es sollte jedoch verstanden werden, dass das zweite Modulteil 104 eine beliebige Anzahl von beweglichen Teilen 150 umfassen kann. Insbesondere kann das zweite Modulteil 104 nur ein bewegliches Teil 150 umfassen, beispielsweise ebenfalls in Fig. 2 und 3 dargestellt. Im Folgenden wird nun die Funktion eines beweglichen Teils detaillierter beschrieben.

In dem dargestellten Ausführungsbeispiel des zweiten Modulteils (Busmodulteil) 104 sind (in einer Richtung von rechts nach links gesehen) das erste bewegliche Teil 150, das zweite bewegliche Teil 150a und das vierte bewegliche Teil 150c in der ersten Position. Nur das dritte bewegliche Teil 150b ist hier in der zweiten Position. Wie in Fig. 13 zu sehen, weist das zweite Modulteil (Busmodulteil) 104 einen ersten Kontaktpunkt 156 auf, der mit dem ersten Busanschluss 117' elektrisch verbunden ist, und einen zweiten Kontaktpunkt 158, der mit dem zweiten Busanschluss 117' elektrisch verbunden ist. Die Isolierstelle 152 befindet sich zwischen dem ersten Kontaktpunkt 156 und dem zweiten Kontaktpunkt 158, wenn das bewegliche Teil 150 in der zweiten Position ist (bewegliches Teil 150b in Fig. 13). Die Isolierstelle 152 ist hier ein luftgefüllter Bereich.

Das bewegliche Teil 150, 150a-c umfasst jeweils eine elektrische Leitung 154, die derart angeordnet ist, dass durch die elektrische Leitung 154 eine elektrische Verbindung zwischen dem ersten Kontaktpunkt 156 und dem zweiten Kontaktpunkt 158 bzw. zwischen dem ersten Busanschluss 117 und dem zweiten Busanschluss 117' bereitgestellt wird, wenn das bewegliche Teil 150 in der ersten Position ist (bewegliches Teil 150, 150a, 150c in Fig. 13). Jedes der beweglichen Teile 150, 150a-c umfasst hier eine elektrische Leitung, die derart angeordnet ist, dass durch die elektrischen Leitungen 154 eine elektrische Verbindung zwischen dem ersten Busanschluss 117 und dem zweiten Busanschluss 117' bereitgestellt wird, wenn jedes der beweglichen Teile 150, 150a-c in der ersten Position ist. Dies ist in dem in Fig. 13 dargestellten Zustand nicht der Fall, da das bewegliche Teil 150b in der zweiten Position ist, d.h. nicht jedes bewegliche Teil ist in der ersten Position. Jedes der beweglichen Teile 150, 150a-c kann also in seiner zweiten Position eine Isolierstelle 152 zwischen dem ersten Busanschluss 117 und dem zweiten Busanschluss 117' bereitstellen. In dem in Fig. 13 dargestellten Zustand ist dies nur das bewegliche Teil 150b. Durch diese Isolierstelle 152 wird der Versorgungsspannungsbus auf getrennt.

Wie in Fig. 14a zu sehen, ist das bewegliche Teil 150, 150a-c ein auf einer Führung 164 geführtes Schiebeelement, das zwischen der ersten und der zweiten Position verschiebbar ist. Das Schiebeelement umfasst einen unteren Bereich (in Bezug auf die Grenzfläche 105a oder Backplane), auf dem die elektrischen Verbindungen angeordnet sind, und einen oberen Bereich (in Bezug auf die Grenzfläche 105a oder Backplane), der zum manuellen Bedienen ausgebildet ist. Wie in Fig. 12 zu sehen ist das bewegliche Teil bzw. Schiebeelement mit dem oberen Bereich auf bzw. über der Grenzebene G bzw. der Grenzfläche 105a des zweiten Modulteils 105 angeordnet, so dass es leicht von außen zugänglich ist. Wie in Fig. 14a zu sehen, ist das Schiebeelement in diesem Ausführungsbeispiel linear zwischen der ersten und zweiten Position verschiebbar, parallel zu (bzw. in) der Grenzfläche 105a oder Backplane. Es sollte verstanden werden, dass das bewegliche Teil oder das Schiebeelement auf jede andere geeignete Art und Weise zwischen der ersten und der zweiten Position beweglich sein kann. Beispielsweise kann das Schiebeelement winkelförmig um einen definierten Drehpunkt zwischen der ersten und zweiten Position verschiebbar bzw. drehbar sein. In einem anderen Beispiel kann das bewegliche Teil ein Jumper sein, der in der ersten Position in die Isolierstelle eingesetzt werden kann oder eingesetzt ist und in der zweiten Position von der Steuerungsvorrichtung abgenommen werden kann oder abgenommen ist. Unter einem Jumper ist hier ein separates, komplett abnehmbares Bauteil mit einer elektrischen Leitung zu verstehen.

Das erste Modulteil (Elektronikmodulteil) 102, wie beispielsweise in Bezug auf die vorhergehenden Figuren beschrieben, wird hier insbesondere in einer ersten Bauform und einer zweiten Bauform bereitgestellt. Die erste Bauform des ersten Modulteils (Elektronikmodulteil) 102 kann hier ein Ein-/Ausgabemodulteil sein (z.B. für Fail Safe (FS-) oder Standard (ST-Anwendung)). In der zweiten Bauform kann das erste Modulteil (Elektronikmodulteil) 102 ein Spannungsversorgungsmodulteil (bzw. Einspeisemodulteil) sein zur Einspeisung eines Module Supply, d.h. einer internen Versorgungsspannung, oder zur Einspeisung eines Periphery Supply, d.h. einer externen Spannungsversorgung, um eine neue Potentialgruppe zu bilden.

In der zweiten Bauform (Spannungsversorgungsmodulteil) ist mindestens ein erster Kontakt 120' (insbesondere Kontakte 120' der zweiten Gruppe, wie zuvor beschrieben) bzw. Leiterplatte 121' des ersten Modulteils 102 derart angeordnet, dass diese in die Isolierstelle 152 eingeführt werden kann. Einer der Kontaktpunkte 156, 158 ist der elektrische Gegenkontakt 130 des zweiten Modulteils (Busmodulteil) 104. Es wird so in der ersten zusammengesetzten Anordnung der erste elektrische Kontakt 120' des ersten Modulteils (Elektronikmodulteil oder Spannungsversorgungsmodulteil) den einen Kontaktpunkt 156, 158 des zweiten Modulteils (Busmodulteil) kontaktiert zur elektrischen Verbindung zwischen dem ersten Modulteil 102 und dem zweiten Modulteil 104, wenn das bewegliche Teil 150 in der zweiten Position ist. Es wird so ein Einspeiseanschluss 160 bereitgestellt. Der Einspeiseanschluss 160 dient zur Verbindung mit dem ersten Modulteil (Spannungsversorgungsmodulteil bzw. Einspeisemodulteil) 102. Das erste Modulteil (Elektronikmodulteil) 102 hat also in der zweiten Bauform (Spannungsversorgungsmodulteil) seinen ersten elektrischen Kontakt 120' derart angeordnet, dass in der ersten zusammengesetzten Anordnung der erste elektrische Kontakt 120 mit dem Einspeiseanschluss 160 eine elektrische Verbindung zwischen dem ersten Modulteil 102 und dem zweiten Modulteil 104 bereitgestellt wird. Auf diese Weise wird von dem ersten Modulteil (Elektronikmodulteil bzw. Spannungsversorgungsmodulteil) 102 auf das zweite Modulteil (Busmodulteil) eine Spannung eingespeist.

Das zweite Modulteil (Busmodulteil) 104 umfasst weiterhin einen weiteren Anschluss 170, der mit der elektrischen Verbindung zwischen dem ersten Busanschluss 117 und dem zweiten Busanschluss 117' verbunden ist. Das erste Modulteil (Elektronikmodulteil) 102 hat in der ersten Bauform (Ein-/Ausgabemodulteil) seinen ersten elektrischen Kontakt 120' bzw. die Leiterplatte 121' derart angeordnet, dass in der ersten zusammengesetzten Anordnung der erste elektrische Kontakt 120' zusammen mit dem weiteren Anschluss 170 eine elektrische Verbindung zwischen dem ersten Modulteil (Elektronikmodulteil bzw. Ein-/Ausgabemodulteil) und dem zweiten Modulteil (Busmodulteil) 104 bereitstellt.

Wie in Fig. 13 durch Pfeile dargestellt, wird in diesem Ausführungsbeispiel die Versorgungsspannung auf dem Versorgungsspannungsbus von dem ersten Busanschluss 117 in Richtung des zweiten Busanschlusses 117' durchgeschaltet, hier also von links nach rechts in Längsrichtung L. Daher ist der oben beschriebene Kontaktpunkt hier der rechte Kontaktpunkt 158. Der Kontaktpunkt 158 wird also von dem ersten elektrischen Kontakt 120' des ersten Modulteils 102 kontaktiert. Der erste elektrische Kontakt 120' des ersten Modulteils 102 ist gegenüber dem anderen Kontaktpunkt 156 des zweiten Modulteils 104 isoliert. Auf diese Weise kann eine neue Spannung nach rechts hin eingespeist werden.

Es wird durch das oben beschrieben Ausführungsbeispiel also erreicht, dass, wenn das bewegliche Teil 150, 150a-c in der ersten Position ist, eine an einem der Busanschlüsse 117 anliegende Spannung zwischen dem ersten Busanschluss 117 und dem zweiten Busanschluss 117' durchgeschaltet wird, und, wenn das bewegliche Teil 150, 150a-c in der zweiten Position ist, eine galvanische Trennung zwischen dem ersten Busanschluss 117 und dem zweiten Busanschluss 117' bereitgestellt wird.

Anstelle von zwei unterschiedlichen Bauformen des zweiten Modulteils (Busmodulteil) 104 (eine Bauart mit durchgeschaltetem Bus und eine Bauart mit aufgetrenntem Bus) wird hier also nur eine einzige Bauart des zweiten Modulteils (Busmodulteil) 104 benötigt. Die Herstellungskosten sind durch die Herstellung nur einer Bauform des zweiten Modulteils (Busmodulteil) 104 geringer. Zudem wird eine erhöhte Benutzerfreundlichkeit bereitgestellt, da jede Bauart des ersten Modulteils (Elektronikmodulteil) 102 auf das zweite Modulteil (Busmodulteil) 104 aufgesetzt werden kann.

## Patentansprüche

1. Steuerungsvorrichtung (1) zum automatisierten Steuern einer technischen Anlage (10), mit zumindest einem Modul (100), das zumindest ein erstes Modulteil (102), ein zweites Modulteil (104), und ein drittes Modulteil (106) umfasst, wobei das zweite Modulteil (104) ein Busmodulteil ist und ein Gehäuse, mindestens einen ersten elektrischen Busanschluss an einer ersten Seite des Gehäuses zur elektrischen Verbindung mit einem in Längsrichtung danebenliegenden ersten Nachbarmodulteil, und mindestens einen zweiten elektrischen Busanschluss an einer zweiten, der ersten Seite gegenüberliegenden Seite des Gehäuses zur elektrischen Verbindung mit einem in Längsrichtung daneben liegenden zweiten Nachbarmodulteil umfasst, wobei das erste Modulteil (102) und das zweite Modulteil (104) mechanisch und elektrisch in eine erste zusammengesetzte Anordnung zusammen gesetzt werden können, wobei das erste Modulteil (102) und das dritte Modulteil (106) mechanisch und elektrisch in eine zweite zusammengesetzte Anordnung zusammen gesetzt werden können, wobei das erste Modulteil (102) zumindest einen ersten elektrischen Kontakt (120) umfasst, und wobei das zweite Modulteil (104) zumindest einen ersten elektrischen Gegenkontakt (130) umfasst, der in der ersten zusammengesetzten Anordnung den ersten elektrischen Kontakt (120) zur elektrische Verbindung zwischen dem ersten und dem zweiten Modulteil (102, 104) kontaktiert, wobei das dritte Modulteil (106) zumindest einen zweiten elektrischen Kontakt (132) umfasst, und wobei das erste Modulteil (102) zumindest einen zweiten elektrischen Gegenkontakt (122) umfasst, der in der zweiten zusammengesetzten Anordnung den zweiten elektrischen Kontakt (132) zur elektrische Verbindung zwischen dem ersten und dem dritten Modulteil (102, 106) kontaktiert, wobei das erste Modulteil (102) ein Sicherungselement (114) mit einem Sicherungseingriffsabschnitt (114b) umfasst, das in eine erste und eine zweite Position beweglich ist, wobei der Sicherungseingriffsabschnitt (114b) in der ersten Position mit dem zweiten Modulteil (104) in der ersten zusammengesetzten Anordnung im sichernden Eingriff ist, so dass das erste Modulteil (102) und das zweite Modulteil (104) aneinander gesichert sind, und wobei der Sicherungseingriffsabschnitt (114b) in der zweiten Position in der ersten zusammengesetzten Anordnung derart angeordnet ist, dass das erste Modulteil (102) und das zweite Modulteil (104) voneinander lösbar sind, wobei das Sicherungselement (114) einen Sicherungsbetätigungsabschnitt (114a) umfasst mittels dessen das Sicherungselement (114) in der ersten zusammengesetzten Anordnung zwischen der ersten und zweiten Position beweglich ist bei Ausüben einer Kraft auf den Sicherungsbetätigungsabschnitt (114a), wobei der Sicherungsbetätigungsabschnitt (114a) in der ersten Position in einem ersten Raumbereich (R1) und in der zweiten Position in einem zweiten Raumbereich (R2) angeordnet ist, und wobei das dritte Modulteil (106) einen Blockierabschnitt (113) aufweist, der in der zweiten zusammengesetzten Anordnung zumindest teilweise in dem zweiten Raumbereich (R2) angeordnet ist, wobei der Blockierabschnitt (113) derart ausgebildet ist, dass das Sicherungselement (114) in der ersten und zweiten zusammengesetzten Anordnung daran gehindert wird, sich in die zweite Position zu bewegen, in der das erste Modulteil (102) und das zweite Modulteil (104) voneinander lösbar wären, so dass das Abnehmen oder Lösen des ersten Modulteils (102) vom zweiten Modulteil (104) nur möglich ist, wenn das dritte Modulteil (106) demontiert ist.

2. Steuerungsvorrichtung nach Anspruch 1, wobei der Blockierabschnitt (113) einen Vorsprung umfasst, der den Sicherungsbetätigungsabschnitt (114a) kontaktiert.

3. Steuerungsvorrichtung nach Anspruch 1 oder 2, wobei das dritte Modulteil (106) ein Schwenkhalterungselement (112) aufweist, an dem das erste Modulteil (102) lösbar gehalten werden kann, wobei das Schwenkhalterungselement (112) des dritten Modulteils (106) einen Schwenkpunkt (S') mit einer Schwenkachse (A') definiert, so dass das erste Modulteil (102) und das dritte Modulteil (106) durch eine Schwenkbewegung entlang einer definierten Bewegungsbahn in die zweite zusammengesetzte Anordnung zusammengesetzt werden können.

4. Steuerungsvorrichtung nach Anspruch 3, wobei der Blockierabschnitt (113) zumindest ein Teil des Schwenkhalterungselements (112) ist.

5. Steuerungsvorrichtung nach einem der Ansprüche 1 bis 4, wobei das erste Modulteil (102) ein Schwenkhalterungselement (110) aufweist, an dem das zweite Modulteil (104) lösbar gehalten werden kann, wobei das Schwenkhalterungselement (110) des ersten Modulteils (102) einen Schwenkpunkt (S) mit einer Schwenkachse (A) definiert, so dass das erste Modulteil (102) und das zweite Modulteil (104) durch eine Schwenkbewegung entlang einer definierten Bewegungsbahn in die erste zusammengesetzte Anordnung zusammengesetzt werden können.

6. Steuerungsvorrichtung nach einem der Ansprüche 1 bis 5, wobei der Sicherungseingriffsabschnitt (114b) ein Vorsprung oder Balken ist, der in der ersten Position in sicherndem Eingriff mit einer Aussparung (115b) des zweiten Modulteils (104) ist.

7. Steuerungsvorrichtung nach einem der Ansprüche 1 bis 6, wobei das Sicherungselement (114) ein Hebel mit einem definierten Fixpunkt (F) ist.

8. Steuerungsvorrichtung nach Anspruch 7, wobei der Hebel ein zweiseitiger Hebel mit einem ersten und einem zweiten Hebelteil bezüglich des Fixpunktes (F) ist, und wobei sich der Sicherungsbetätigungsabschnitt (114a) auf dem ersten Hebelteil befindet und wobei sich der Sicherungseingriffsabschnitt (114b) auf dem zweiten Hebelteil befindet.

9. Steuerungsvorrichtung nach Anspruch 7, wobei der Hebel ein einseitiger Hebel ist.

10. Steuerungsvorrichtung nach einem der Ansprüche 7 bis 9, wobei der Sicherungsbetätigungsabschnitt (114a) des Hebels in einer Richtung in einer Ebene (EF) beweglich ist, die senkrecht zu einer durch den Fixpunkt (F) definierten Fixpunktachse (FA) angeordnet ist, wobei der Sicherungsbetätigungsabschnitt (114a) in der ersten Position in einer ersten Winkellage in der Ebene (EF) angeordnet ist, und wobei der Sicherungsbetätigungsabschnitt (114a) in der zweite Position in einer anderen, zweite Winkellage in der Ebene (EF) angeordnet ist.

11. Steuerungsvorrichtung nach Anspruch 10, wobei der Blockierabschnitt (113) in der zweiten zusammengesetzten Anordnung zumindest teilweise in einem Bereich zwischen der ersten Winkellage und der zweiten Winkellage angeordnet ist.

12. Steuerungsvorrichtung nach einem der Ansprüche 1 bis 11, wobei das erste Modulteil (102) ein weiteres Gehäuse (103) umfasst, und wobei das Sicherungselement (114) an dem weiteren Gehäuse (103) befestigt ist.

13. Steuerungsvorrichtung nach einem der Ansprüche 1 bis 12, wobei das erste Modulteil (102) eine Signalverarbeitungseinheit umfasst, und/oder wobei das dritte Modulteil (106) zumindest einen externen Anschluss (129) zum Anlegen eines Signals oder einer Spannung umfasst.

14. Steuerungsvorrichtung nach einem der Ansprüche 1 bis 13, wobei der erste und zweite elektrische Busanschluss für einen Kommunikationsbus oder Versorgungsspannungsbus ausgebildet sind,

15. Steuerungsvorrichtung nach den Ansprüchen 3 und 5, wobei das Schwenkhaltungselement (110) des ersten Modulteils (102) und das Schwenkhalterungselement (112) des dritten Modulteils (106) an sich einander gegenüberliegenden Seiten des Moduls (100) angeordnet sind, wobei das dritte Modulteil (106) in eine erste Richtung abschwenkbar ist und das erste Modulteils (102) in eine zweite, der ersten entgegengesetzte Richtung abschwenkbar ist.

## Claims

1. A control apparatus (1) for automatedly controlling a technical installation (10), comprising at least one module (100) having at least a first module part (102), a second module part (104), and a third module part (106), wherein the second module part (104) is a bus module part and comprises a housing, at least one first electrical bus connection on a first side of the housing for electrical connection to a first neighboring module part which is adjacent in the longitudinal direction, and at least one second electrical bus connection on a second side, opposite the first side, of the housing for the electrical connection to a second neighboring module part which is adjacent in the longitudinal direction, wherein the first module part (102) and the second module part (104) can be mechanically and electrically combined to form a first combined arrangement, wherein the first module part (102) and the third module part (106) can be mechanically and electrically combined to form a second combined arrangement, wherein the first module part (102) comprises at least one first electrical contact (120), and wherein the second module part (104) comprises at least one first electrical mating contact (130), which, in the first combined arrangement, makes contact with the first electrical contact (120) of the first module part (102) for electrical connection between the first and second module parts (102, 104), wherein the third module part (106) comprises at least one second electrical contact (132), and wherein the first module part (102) comprises at least one second electrical mating contact (122), which, in the second combined arrangement, makes contact with the second electrical contact (132) for electrical connection between the first and third module parts (102, 106), wherein the first module part (102) comprises a securing element (114) with a securing engagement section (114b) which is moveable into a first and a second position, wherein the securing engagement section (114b), in the first position, is in securing engagement with the second module part (104) in the first combined arrangement, with the result that the first module part (102) and the second module part (104) are secured against one another, and wherein the securing engagement section (114b), in the second position, is arranged in the first combined arrangement in such a way that the first module part (102) and the second module part (104) are detachable from one another, wherein the securing element (114) comprises a securing actuation section (114a) by means of which the securing element (114), in the first combined arrangement, is moveable between the first and second positions when a force is exerted on the securing actuation section (114a), wherein the securing actuation section (114a), in the first position, is arranged in a first spatial region (R1) and, in the second position, is arranged in a second spatial region (R2), and wherein the third module part (106) has a blocking section (113), which, in the second combined arrangement, is arranged at least partially in the second spatial region (R2), wherein the blocking section (113) is designed such that the securing element (114), in the first and second combined arrangements, is prevented from moving into the second position, in which the first module part and the second module part would be detachable from one another, such that removal or detachment of the first module part (102) from the second module part (104) is only possible when the third module part (106) has been removed.

2. The control apparatus of claim 1, wherein the blocking section (113) comprises a projection, which makes contact with the securing actuation section (114a).

3. The control apparatus of claim 1 or 2, wherein the third module part (106) has a pivoting holder element (112), on which the first module part (102) can be detachably held, wherein the pivoting holder element (112) of the third module part (106) defines a pivot point (S') with a pivot axis (A'), with the result that the first module part (102) and the third module part (106) can be combined to form the second combined arrangement by a pivoting movement along a defined movement path.

4. The control apparatus of claim 3, wherein the blocking section (113) is at least part of the pivoting holder element (112).

5. The control apparatus of one of claims 1 to 4, wherein the first module part (102) has a pivoting holder element (110), on which the second module part (104) can be detachably held, wherein the pivoting holder element (110) of the first module part (102) defines a pivot point (S) with a pivot axis (A), with the result that the first module part (102) and the second module part (104) can be combined to form the first combined arrangement by a pivoting movement along a defined movement path.

6. The control apparatus of one of claims 1 to 5, wherein the securing engagement section (114b) is a projection or bar, which, in the first position, is in securing engagement with a cutout (115b) in the second module part (104).

7. The control apparatus of one of claims 1 to 6, wherein the securing element (114) is a lever with a defined fixpoint (F).

8. The control apparatus of claim 7, wherein the lever is a two-sided lever with a first lever part and a second lever part with respect to the fixpoint (F), and wherein the securing actuation section (114a) is located on the first lever part, and wherein the securing engagement section (114b) is located on the second lever part.

9. The control apparatus of claim 7, wherein the lever is a one-sided lever.

10. The control apparatus of one of claims 7 to 9, wherein the securing actuation section (114a) of the lever is moveable in a direction in a plane (EF) which is perpendicular to a fixpoint axis (FA) defined by the fixpoint (F), wherein the securing actuation section (114a), in the first position, is arranged in a first angular position in the plane (EF), and wherein the securing actuation section (114a), in the second position, is arranged in another, second angular position in the plane (EF).

11. The control apparatus of claim 10, wherein the blocking section (113), in the second combined arrangement, is arranged at least partially in a region between the first angular position and the second angular position.

12. The control apparatus of one of claims 1 to 11, wherein the first module part (102) comprises a further housing (103), and wherein the securing element (114) is fastened to the further housing (103).

13. The control apparatus of one of claims 1 to 12, wherein the first module part (102) comprises a signal processing unit, and/or wherein the third module part (106) comprises at least one external connector (129) for supplying a signal or a voltage.

14. The control apparatus of one of claims 1 to 13, wherein the first and the second electrical bus connection are designed for a communication bus or a voltage supply bus.

15. The control apparatus of claims 3 and 5, wherein the pivoting holder element (110) of the first module part (102) and the pivoting holder element (112) of the third module part (106) are arranged on mutually opposite sides of the module (100), wherein the third module part (106) can be pivoted away in a first direction and the first module part (102) can be pivoted away in a second direction opposite the first direction.

## Revendications

1. Dispositif de commande (1) destiné à la commande automatisée d'un équipement technique (10), comprenant au moins un module (100) qui comporte au moins une première partie de module (102), une deuxième partie de module (104) et une troisième partie de module (106), la deuxième partie de module (104) étant une partie de module de bus et comportant un boîtier, au moins une première borne de bus électrique au niveau d'un premier côté du boîtier destinée à la connexion électrique avec une première partie de module voisine adjacente dans le sens longitudinal, et au moins une deuxième borne de bus électrique au niveau d'un deuxième côté du boîtier, à l'opposé du premier côté, destinée à la connexion électrique avec une deuxième partie de module voisine adjacente dans le sens longitudinal, la première partie de module (102) et la deuxième partie de module (104) pouvant être assemblées mécaniquement et électriquement dans un premier arrangement assemblé, la première partie de module (102) et la troisième partie de module (106) pouvant être assemblées mécaniquement et électriquement dans un deuxième arrangement assemblé, la première partie de module (102) comportant au moins un premier contact électrique (120), et la deuxième partie de module (104) comportant au moins un premier contact homologue électrique (130) qui, dans le premier arrangement assemblé, entre en contact avec le premier contact électrique (120) en vue de la connexion électrique entre la première et la deuxième partie de module (102, 104), la troisième partie de module (106) comportant au moins un deuxième contact électrique (132), et la première partie de module (102) comportant au moins un deuxième contact homologue électrique (122) qui, dans le deuxième arrangement assemblé, entre en contact avec le deuxième contact électrique (132) en vue de la connexion électrique entre la première et la troisième partie de module (102, 106), la première partie de module (102) comportant un élément de verrouillage (114) pourvu d'une portion de mise en prise de verrouillage (114b) qui peut être déplacée dans une première et une deuxième position, la portion de mise en prise de verrouillage (114b), dans la première position, étant en prise de verrouillage avec la deuxième partie de module (104) dans le premier arrangement assemblé, de sorte que la première partie de module (102) et la deuxième partie de module (104) sont verrouillées l'une contre l'autre, et la portion de mise en prise de verrouillage (114b), dans la deuxième position dans le premier arrangement assemblé étant disposée de telle sorte que la première partie de module (102) et la deuxième partie de module (104) peuvent être séparées l'une de l'autre, l'élément de verrouillage (114) comportant une portion d'actionnement de verrouillage (114a) au moyen de laquelle l'élément de verrouillage (114) dans le premier arrangement assemblé peut être déplacé entre la première et la deuxième position en exerçant une force sur la portion d'actionnement de verrouillage (114a), la portion d'actionnement de verrouillage (114a) dans la première position étant disposée dans une première zone d'espace (R1) et dans la deuxième position dans une deuxième zone d'espace (R2), et la troisième partie de module (106) possédant une portion de blocage (113) qui, dans le deuxième arrangement assemblé, est disposée au moins partiellement dans la deuxième zone d'espace (R2), la portion de blocage (113) étant configurée de telle sorte que l'élément de verrouillage (114) dans le premier et le deuxième arrangement assemblé est empêché de se déplacer dans la deuxième position, dans laquelle la première partie de module (102) et la deuxième partie de module (104) pourraient être séparées l'une de l'autre, de sorte que le retrait ou la séparation de la première partie de module (102) de la deuxième partie de module (104) n'est possible que lorsque la troisième partie de module (106) est démontée.

2. Dispositif de commande selon la revendication 1, la portion de blocage (113) comportant une partie saillante qui entre en contact avec la portion d'actionnement de verrouillage (114a).

3. Dispositif de commande selon la revendication 1 ou 2, la troisième partie de module (106) possédant un élément de maintien pivotant (112) auquel la première partie de module (102) peut être maintenue de manière amovible, l'élément de maintien pivotant (112) de la troisième partie de module (106) définissant un point de pivotement (S') avec un axe de pivotement (A'), de sorte que la première partie de module (102) et la troisième partie de module (106) peuvent être assemblées dans le deuxième arrangement assemblé par un mouvement de pivotement le long d'une trajectoire de déplacement définie.

4. Dispositif de commande selon la revendication 3, la portion de blocage (113) étant au moins une partie de l'élément de maintien pivotant (112).

5. Dispositif de commande selon l'une des revendications 1 à 4, la première partie de module (102) possédant un élément de maintien pivotant (110) auquel la deuxième partie de module (104) peut être maintenue de manière amovible, l'élément de maintien pivotant (110) de la première partie de module (102) définissant un point de pivotement (S) avec un axe de pivotement (A), de sorte que la première partie de module (102) et la deuxième partie de module (104) peuvent être assemblées dans le premier arrangement assemblé par un mouvement de pivotement le long d'une trajectoire de déplacement définie.

6. Dispositif de commande selon l'une des revendications 1 à 5, la portion de mise en prise de verrouillage (114b) étant une partie saillante ou une barre qui, dans la première position, est en prise de verrouillage avec un évidement (115b) de la deuxième partie de module (104).

7. Dispositif de commande selon l'une des revendications 1 à 6, l'élément de verrouillage (114) étant un levier avec un point fixe (F) défini.

8. Dispositif de commande selon la revendication 7, le levier étant un levier bilatéral avec une première et une deuxième partie de levier par rapport au point fixe (F), et la portion d'actionnement de verrouillage (114a) se trouvant sur la première partie de levier et la portion de mise en prise de verrouillage (114b) se trouvant sur la deuxième partie de levier.

9. Dispositif de commande selon la revendication 7, le levier étant un levier unilatéral.

10. Dispositif de commande selon l'une des revendications 7 à 9, la portion d'actionnement de verrouillage (114a) du levier étant mobile dans une direction dans un plan (EF) qui est disposé perpendiculairement à un axe de point fixe (FA) défini par le point fixe (F), la portion d'actionnement de verrouillage (114a) dans la première position étant disposée dans une première position angulaire dans le plan (EF), et la portion d'actionnement de verrouillage (114a) dans la deuxième position étant disposée dans une autre, deuxième position angulaire dans le plan (EF).

11. Dispositif de commande selon la revendication 10, la portion de blocage (113) dans le deuxième arrangement assemblé étant disposée au moins partiellement dans une zone entre la première position angulaire et la deuxième position angulaire.

12. Dispositif de commande selon l'une des revendications 1 à 11, la première partie de module (102) comportant un boîtier (103) supplémentaire, et l'élément de verrouillage (114) étant fixé au boîtier (103) supplémentaire.

13. Dispositif de commande selon l'une des revendications 1 à 12, la première partie de module (102) comportant une unité de traitement de signal et/ou la troisième partie de module (106) comportant au moins une borne externe (129) servant à appliquer un signal ou une tension.

14. Dispositif de commande selon l'une des revendications 1 à 13, la première et la deuxième borne de bus électrique étant configurées pour un bus de communication ou un bus de tension d'alimentation.

15. Dispositif de commande selon les revendications 3 et 5, l'élément de maintien pivotant (110) de la première partie de module (102) et l'élément de maintien pivotant (112) de la troisième partie de module (106) se trouvant au niveau de côtés mutuellement opposés du module (100), la troisième partie de module (106) pouvant être pivotée à l'écart dans une première direction et la première partie de module (102) pouvant être pivotée à l'écart dans une deuxième direction, à l'opposé de la première.
